# EUROPEAN PATENT SPECIFICATION

(11) **EP 3 476 052 B1**
(45) Date of publication and mention of the grant of the patent: **30.12.2020**
(21) Application number: 16843274.8
(22) Date of filing: 12.08.2016
(51) Int. Cl.: H03M 13/13, H03M 13/03

(54) **CODING AND DECODING OF POLAR CODES EXTENDED TO LENGTHS WHICH ARE NOT POWERS OF TWO**
CODIERUNG UND DECODIERUNG VON ERWEITERTEN POLARCODES MIT ANDEREN LÄNGEN ALS POTENZEN VON ZWEI
CODAGE ET DÉCODAGE DE CODES POLAIRES ÉTENDUS À DES LONGUEURS AUTRES QUE DES PUISSANCES DE DEUX

(43) Date of publication of application: 01.05.2019
(73) Proprietor: Huawei Technologies Co., Ltd., Longgang District Shenzhen, Guangdong 518129 (CN)
(72) Inventor: KURMAEV, Oleg Feat'evich, Shenzhen Guangdong 518129 (CN); TRIFONOV, Petr Vladimirovich, St.Petersburg 194021 (RU); RAZINKIN, Alexey Mikhailovich, Shenzhen Guangdong 518129 (CN); MAEVSKII, Aleksei Eduardovich, Shenzhen Guangdong 518129 (CN)
(74) Representative: Pfenning, Meinig & Partner mbB
(86) International application number: PCT/RU2016/000539
(87) International publication number: WO 2018/030910

(56) References cited:
- CN-A- 105 141 322
- US-A1- 2015 295 593
- TRIFONOV PETER ET AL: "Polar Subcodes", IEEE JOURNAL ON SELECTED AREAS IN COMMUNICATIONS, IEEE SERVICE CENTER, PISCATAWAY, US, vol. 34, no. 2, February 2016 (2016-02), pages 254-266, XP011593857, ISSN: 0733-8716, DOI: 10.1109/JSAC.2015.2504269 [retrieved on 2016-01-15] cited in the application
- NIU KAI ET AL: "Polar codes: Primary concepts and practical decoding algorithms", IEEE COMMUNICATIONS MAGAZINE, IEEE SERVICE CENTER, PISCATAWAY, US, vol. 52, no. 7, July 2014 (2014-07), pages 192-203, XP011553413, ISSN: 0163-6804, DOI: 10.1109/MCOM.2014.6852102 [retrieved on 2014-07-10]
- MAYANK BAKSHI ET AL: "Concatenated Polar codes", PROC., IEEE INTERNATIONAL SYMPOSIUM ON INFORMATION THEORY, ISIT 2010, IEEE, PISCATAWAY, NJ, USA, 13 June 2010 (2010-06-13), pages 918-922, XP031710549, ISBN: 978-1-4244-7890-3

## Description

### TECHNICAL FIELD

In general, the present invention relates to data encoding and decoding in communication systems. In particular, the present invention relates to apparatuses and methods for encoding data and decoding data using codes based on polar codes or subcodes.

### BACKGROUND

Reliable transmission of data over noisy communication channels usually requires some kind of error correction coding to be used. Polar codes were shown to achieve the Shannon capacity of many channels see E. Arikan, "Channel polarization: A method for constructing) capacity achieving codes for symmetric binary-input memoryless channels", IEEE Trans. on Inf. Theory, vol. 55, no. 7, pp. 3051-3073, July 2009). However, the performance of polar codes with practical parameters is often unsatisfactory.

Polar subcodes (see P. Trifonov and V. Miloslavskaya, "Polar subcodes", IEEE Journal on Selected Areas in Communications, 34(2):254-266, February 2016) were shown to have higher minimum distance than classical polar codes, and provide substantially better performance under list, sequential and block sequential decoding (see I. Tal and A. Vardy, "List decoding of polar codes," in Proc. IEEE Int. Symp. Inf. Theory, Jul. 2011, pp. 1-5 and V. Miloslavskaya and P. Trifonov, "Sequential decoding of polar codes," IEEE Commun. Lett., vol. 18, no. 7, pp. 1127-1130, Jul. 2014). However, the performance of polar subcodes can still be improved.

In general, a (*n* = 2*^{m}*, *k*) polar subcode *C* over *GF*(2) can be defined as a set of vectors *c* = *xWAₘ,* wherein *W* represents a *k* × *n* precoding matrix, ${A}_{m} = {\left(\begin{matrix}1 & 0 \\ 1 & 1\end{matrix}\right)}^{⊗ m}$ represent a polarizing transformation, and *Q*^{⊗*m*} denotes the m-times Kronecker product of a matrix Q with itself. Classical polar codes can be obtained by taking the matrix *W*, such that each column of *W* has weight at most 1, and each row has weight 1. Polar subcodes can be obtained by taking *W* such that the vectors *c* are also codewords of some parent code which has sufficiently high minimum distance, i.e. *H^{T}* = 0, wherein *H* is a check matrix of the parent code. For example, it is shown that extended Bose-Chaudhuri-Hocquenghem (BCH) can be good parent codes.

Another equivalent way to define a polar subcode is to consider it as a set of vectors *c* = *uA,* wherein *uV^{T}* = 0, and wherein *V* is a (*n* - *k*) × *n* constraint matrix, such that *WV^{T}* = 0. By means of a Gaussian elimination, the matrix V can be constructed in such a way that at most one row ends in each column. Afterwards, the following set of constraints on the input symbols *uᵢ* of the polarizing transformation *Aₘ* can be obtained: ${u}_{{j}_{i}} = {\sum }_{s < {j}_{i} : {V}_{is} = 1} {u}_{s} , 0 \leq i < n - k ,$ wherein *jᵢ* is the position of the last non-zero entry in the *i*-th row of *V*. The symbols *jᵢ* are also denoted dynamic frozen symbols. These dynamic frozen symbols can be considered as a generalization of the concept of (static) frozen symbol used in the construction of classical polar codes. A standard way to construct a polar subcode is to construct a matrix *V* = *HA^{T},* where *H* is a check matrix of a parent code, and then introduce additional constraints *u_{jᵢ}* = 0 (static freezing constraints) for symbols with the highest error probability *P_{jᵢ},* wherein *Pᵢ* denotes the bit error probability in the synthetic bit subchannel induced by the polarizing transformation *Aₘ,* wherein a transition probability function can be described as follows: ${W}_{m}^{\left(i\right)} \left({y}_{0}^{n - 1} , {u}_{0}^{i - 1} |{u}_{i}\right) = \frac{1}{{2}^{n - 1}} {\sum }_{{u}_{i + 1}^{n - 1}} {\prod }_{j = 0}^{n - 1} W \left({y}_{j} |{\left({u}_{0}^{n - 1}{A}_{m}\right)}_{j}\right) ,$ wherein *W*(*y*|*c*) is the transition probability function of the underlying binary input memoryless output-symmetric channel, and ${a}_{i}^{j} = \left({a}_{i},…,{a}_{j}\right) .$

Another approach to describe polar subcodes is to define a set *F* of frozen bit indices *jᵢ,* such that *u_{jᵢ}* is either fixed or depends on prior symbols, and to consider a generator matrix *G* of a parent code. Afterwards, a matrix $W = {GA}_{m}^{- 1}$ can be computed and a Gaussian elimination can be applied to this matrix, in order to ensure that distinct rows start (i.e. have the first non-zero entry) in different columns, and then the rows with the highest *P_{sᵢ},* wherein *sᵢ* is the position at which the *i*-th row starts, can be eliminated from the obtained matrix.

All the above described approaches provide codes of length 2*^{m}*. However, for practical applications, the construction of codes having any code length is desirable.

In order to obtain codes having a length different from 2*^{m}*, several techniques can be applied, for example the so-called shortening and puncturing techniques. According to the shortening technique, given a *C*(*N,K,D*) linear block code, a (*n* = *N* - *v, k* = *K* - *v, d* ≥ *D)* shortened code can be obtained from the code *C* as a set of vectors (*c*_{*i*₁},...,*c_{iₙ}*): (*c*₁,...,*c_{N}*) ∈ *C, c_{jₜ}* = 0, *jₜ* ∈ *S*, 1 ≤ *t* ≤ *v, iₛ* ∉ *S,* 1 ≤ *s* ≤ *n* , wherein *S* denotes a set of shortened symbols. According to the puncturing technique, given a (*N,K,D*) linear block code *C*, a (*n* = *N* - *v, k* ≤ *K, d* ≥ *D - v*) punctured code can be obtained from the code *C* as a set of vectors (*c*_{*i*₁},...,*c_{iₙ}*): (*c*₁,...,*c_{N}*) ∈ *C, iₜ* ∉ *P,* 1 ≤ *t* ≤ *n,* wherein *P* denotes a set of punctured symbols. In general, the sets of punctured symbols *P* and the set of shortened symbols *S* need to be optimized in order to obtain a satisfying performance of the code and the choice of the sets *P* and *S* affects the optimal choice of the set *F.* Since the sets *F, P* and *S* have to be jointly optimized, the construction of the code becomes extremely complex. Moreover, heavily shortened or punctured codes do not have a satisfying performance.

Another way to obtain codes of different lengths is to use concatenation techniques. An example of such techniques is given by the so-called X4 construction described in the work by N. J. A. Sloane et al., "New binary codes," IEEE Trans. On Inform. Theory, vol. IT-18, pp. 503-510, July 1972. This construction is based on linear codes *C*₀(*n*₀,*k*₀,*d*₀),*C*₁(*n*₀,*k*₁,*d*₁),*C*₂(*n*₂,*k*₂,*d*₂),*C*₃(*n*₂,*k*₃,*d*₃), such that *C*₀ ⊂ *C*₁, *C*₂ ⊂ *C*₃, *k*₁ - *k*₀ = *k*₃ - *k*₂, and it is assumed that *Cᵢ* has a generator matrix *Gᵢ,* wherein ${G}_{1} = \left(\begin{matrix}{G}_{0} \\ G ′\end{matrix}\right) ,$ *G*₃ = $\left(\begin{matrix}{G}_{2} \\ G "\end{matrix}\right) .$ In such a way, an (*n*₀ + *n*₂, *k*₀ + *k*₃, min(*d*₀,*d*₂,*d*₁ + *d*₃)) code having a generator matrix G given by the following equation: $G = \left(\begin{matrix}{G}_{0} & 0 \\ 0 & {G}_{2} \\ G ′ & G "\end{matrix}\right)$ can be obtained. Another example of a concatenation technique is given by the so-called XX construction described in the work by W. Alltop, "A Method for Extending Binary Linear Codes", IEEE Transactions on Information Theory, 30(6), November 1984, which is based on *Cᵢ*(*nᵢ,kᵢ,dᵢ*), *i* = 1,...,6, codes, wherein *C*₁ = *C*₂ + *C*₃, *C*₄ = *C*₂ ∩ *C*₃, i.e. ${G}_{2} = \left(\begin{matrix}G ′ \\ {G}_{4}\end{matrix}\right) ,$ *G*₃ = $\left(\begin{matrix}G " \\ {G}_{4}\end{matrix}\right) ,$ ${G}_{1} = \left(\begin{matrix}G ′ \\ G " \\ {G}_{4}\end{matrix}\right) ,$ *k*₅ = *k*₂ - *k*₄, *k*₆ = *k*₃ - *k*₄. By means of these codes, an (*n*₁ + *n*₅ + *n*₆, *k*₁, min(*d*₄, *d*₂ + *d*₅, *d*₃ + *d*₆, *d*₁ + *d*₅ + *d*₆)) code having a generator matrix G given by the following equation: $G = \left(\begin{matrix}G ′ & {G}_{5} & 0 \\ G " & 0 & {G}_{6} \\ {G}_{4} & 0 & 0\end{matrix}\right)$ can be obtained. However, the performance of the codes obtained by means of concatenation techniques still can significantly be improved.

Thus, there is a need for improved apparatuses and methods for encoding data and decoding data using codes based on polar codes or subcodes.

### SUMMARY

It is an object of the invention to provide improved apparatuses and methods for encoding data and decoding data using codes based on polar codes or subcodes as well as to specify these codes in an efficient way.

The foregoing and other objects are achieved by the subject matter of the independent claims. Further implementation forms are apparent from the dependent claims, the description and the figures.

The invention can be implemented in hardware and/or software.

### BRIEF DESCRIPTION OF THE DRAWINGS

Further embodiments of the invention will be described with respect to the following figures, wherein:
Fig. 1 shows a schematic diagram illustrating a communication system comprising an encoding apparatus according to an embodiment and a decoding apparatus according to an embodiment;
Fig. 1a shows four exemplary generator matrices of extended BHC codes used to construct a code according to an embodiment;
Fig. 1b shows three exemplary generator matrices of extended BHC codes used to construct a code according to an embodiment;
Fig. 1c shows four exemplary precoding matrices of generator matrices of extended BHC codes used to construct a code according to an embodiment;
Fig. 1d shows three exemplary precoding matrices of generator matrices of extended BHC codes used to construct a code according to an embodiment;
Fig. 1e shows an exemplary precoding matrix of a parent code according to an embodiment;
Fig. 1f shows an exemplary precoding matrix of a code according to an embodiment;
Fig. 1g shows an exemplary constraint matrix of a code according to an embodiment;
Fig. 2 shows a schematic diagram of a structure of an encoding apparatus for a code based on chained polar subcode according to an embodiment;
Fig. 3 shows frame error rates (FER) of different codes as a function of a signal-to-noise ratio (*E_{b}*/*N*₀) in dB according to an embodiment;
Fig. 4 shows frame error rates (FER) of different codes as a function of a signal-to-noise ratio (*E_{b}*/*N*₀) in dB according to an embodiment;
Fig. 5 shows a schematic diagram of a method for encoding data *x* of dimension *k* into a codeword c of length *n* according to an embodiment; and
Fig. 6 shows a schematic diagram of a method for decoding a codeword c of length *n* according to an embodiment.

In the figures, identical reference signs will be used for identical or functionally equivalent features.

### DETAILED DESCRIPTION OF EMBODIMENTS

In the following description, reference is made to the accompanying drawings, which form part of the disclosure, and in which are shown, by way of illustration, specific aspects in which the present invention may be placed. It will be appreciated that the invention may be placed in other aspects and that structural or logical changes may be made without departing from the scope of the invention. The following detailed description, therefore, is not to be taken in a limiting sense, as the scope of the invention is defined by the appended claims.

For instance, it will be appreciated that a disclosure in connection with a described method will generally also hold true for a corresponding device or system configured to perform the method and vice versa. For example, if a specific method step is described, a corresponding device may include a unit to perform the described method step, even if such unit is not explicitly described or illustrated in the figures.

Moreover, in the following detailed description as well as in the claims, embodiments with functional blocks or processing units are described, which are connected with each other or exchange signals. It will be appreciated that the invention also covers embodiments which include additional functional blocks or processing units that are arranged between the functional blocks or processing units of the embodiments described below.

Finally, it is understood that the features of the various exemplary aspects described herein may be combined with each other, unless specifically noted otherwise.

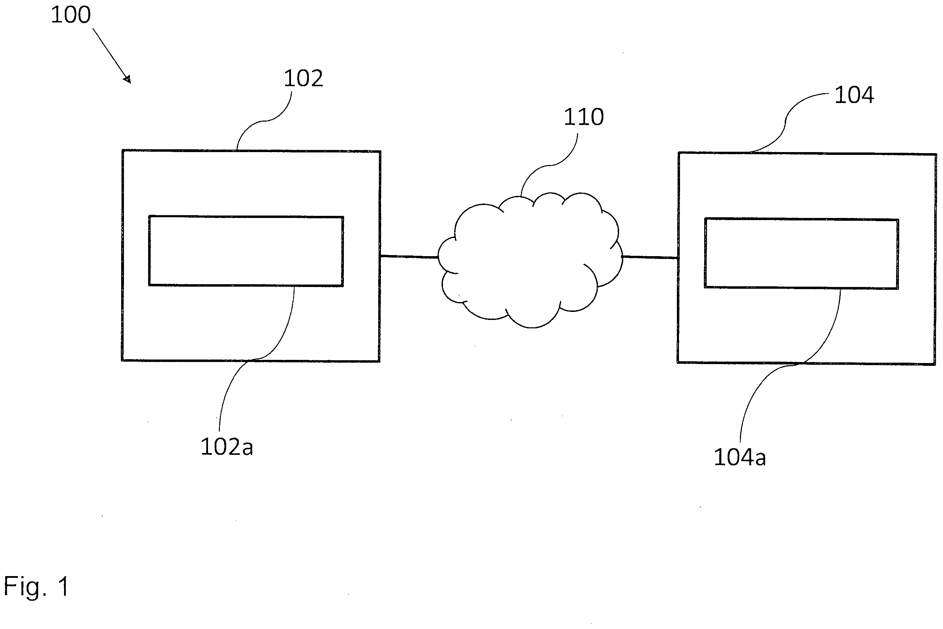

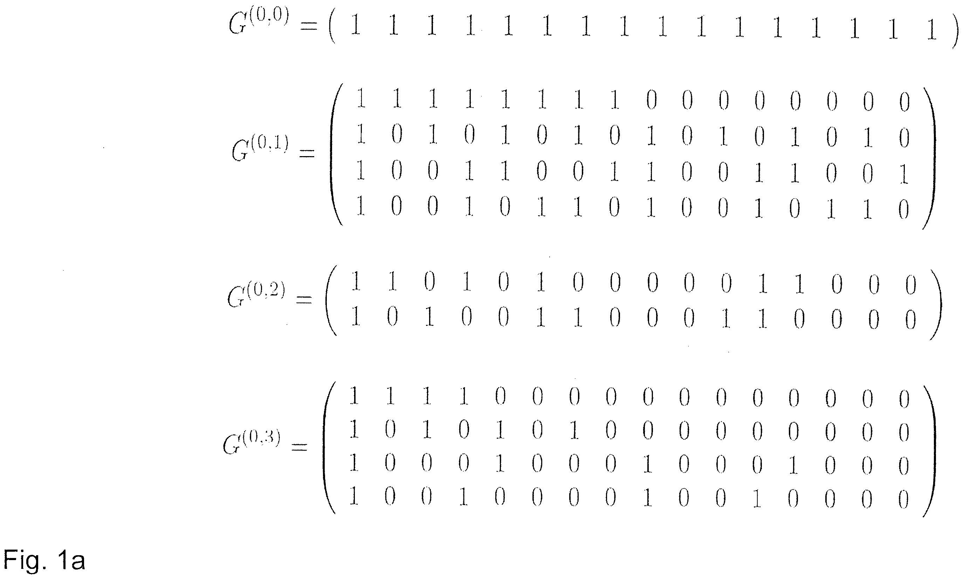

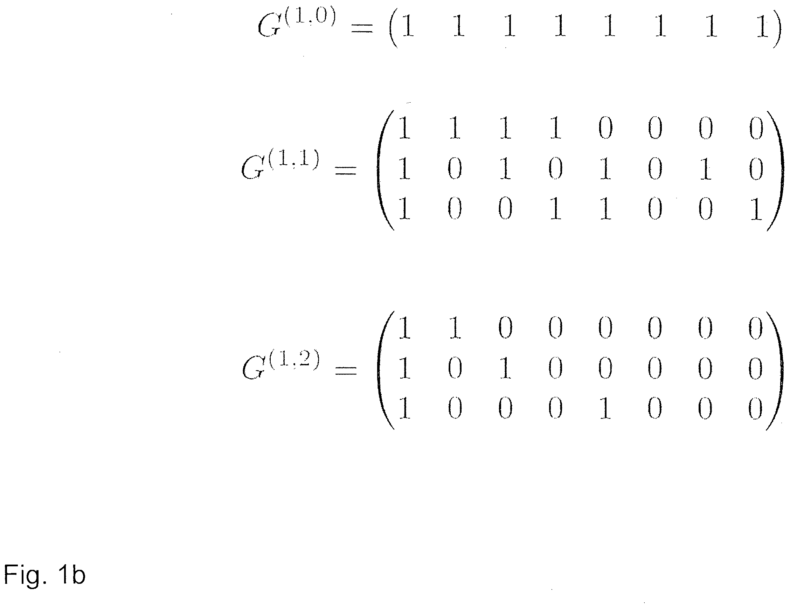

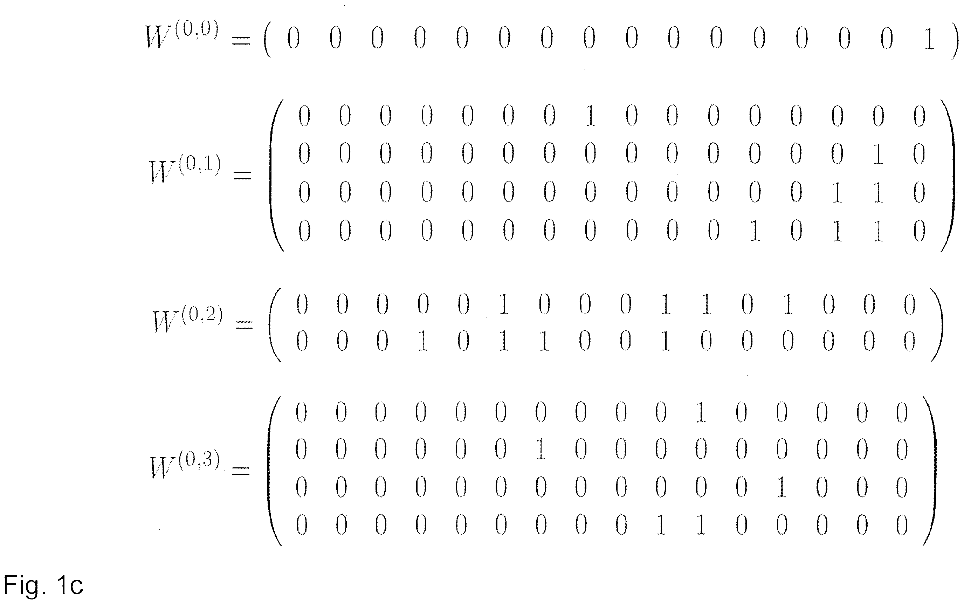

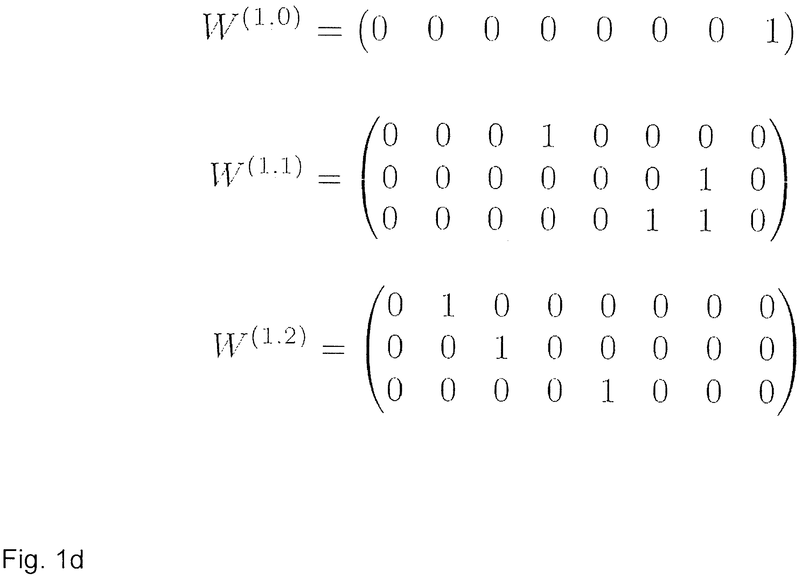

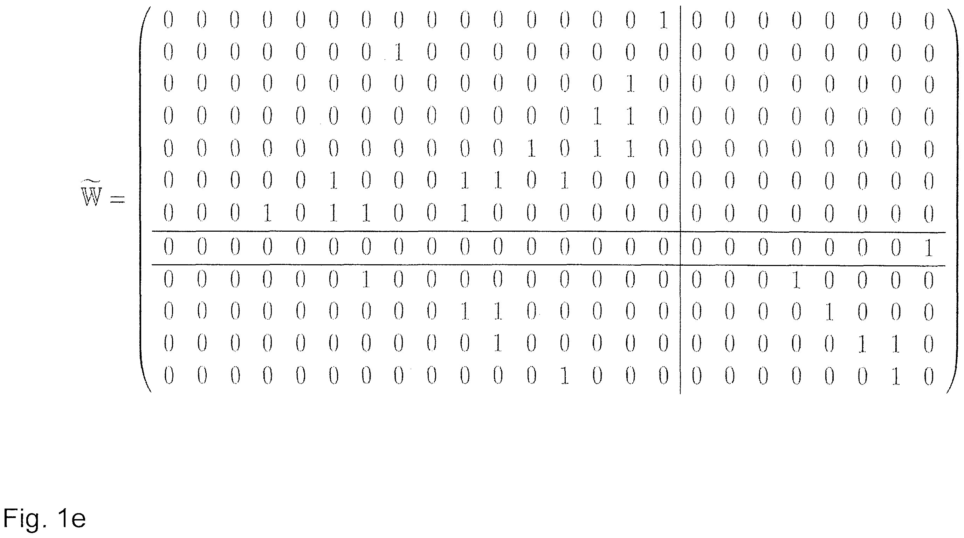

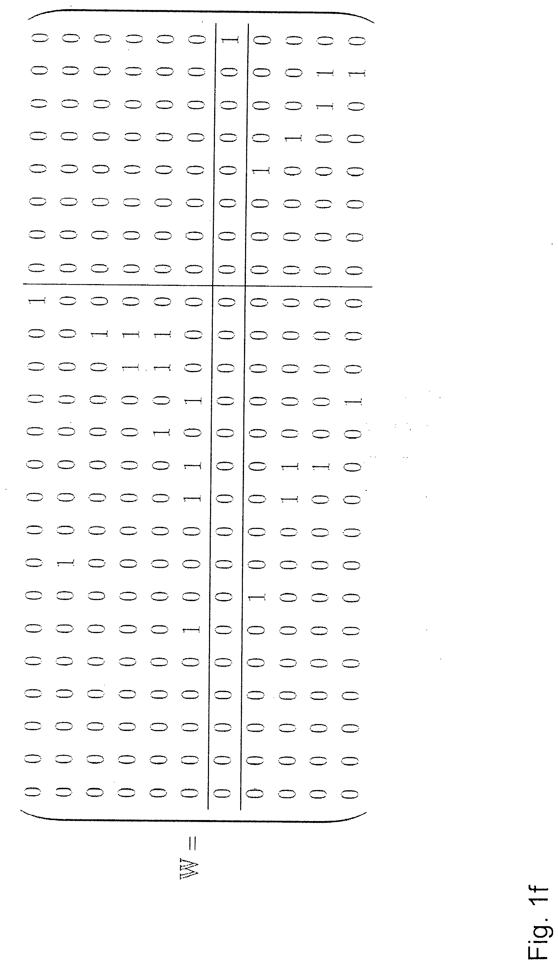

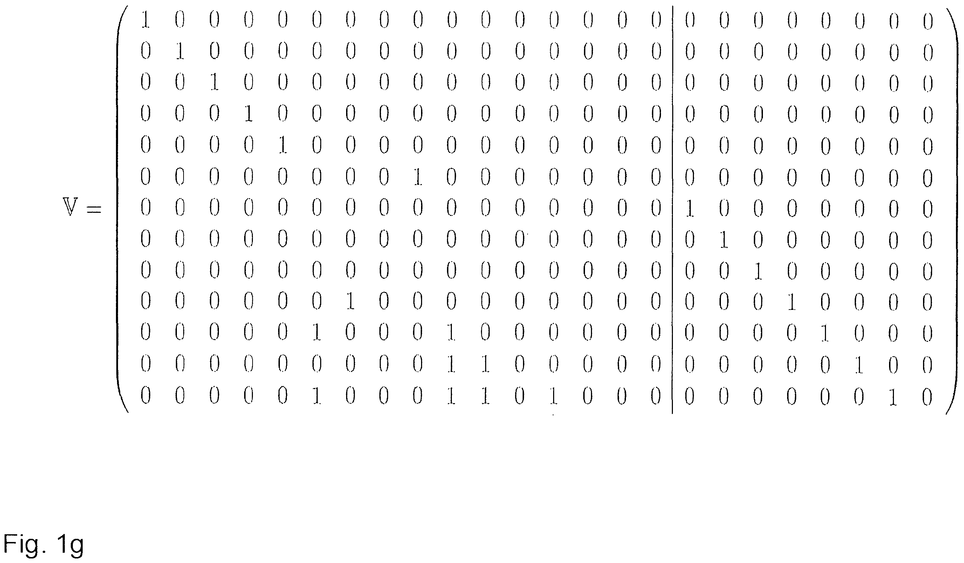

Figure 1 shows a schematic diagram illustrating a communication system 100 comprising an encoding apparatus 102 and a decoding apparatus 104, which can communicate via a communication channel 110.

The encoding apparatus 102 comprises a processor 102a and is configured to encode data. Likewise, the decoding apparatus 104 comprises a processor 104a and is configured to decode data, in particular data encoded by the encoding apparatus 102. The encoding apparatus 102 and/or the decoding apparatus 104 can be implemented as part of a communication device, such as a mobile phone or a base station of a cellular communication network.

In an embodiment, the processor 102a is configured to encode data *x* of dimension *k* into a codeword *c* of length *n* using a *C*(*n,k,d*) code, wherein the code *C*(*n,k,d*) has a length *n* and a minimum distance *d*, wherein *n* = 2^{*m*₁} + ··· + 2*^{mₛ}*, wherein *mₕ* > *m*_{*h*+1}, *h* = 1,...,*s*, is an integer number, on the basis of the equation: $c = u A ,$ wherein *uᵢ* = *x_{jᵢ}*, 0 ≤ *jᵢ < k* - 1, if *i* ∉ *F,* wherein *F* is a set of *n* - *k* frozen bit indices of the code *C*(*n,k,d*), and 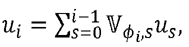 if *i* ∈ *F*, wherein 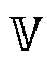 is a constraint matrix.
The constraint matrix 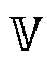 is given by a solution of the equation: 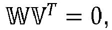 wherein *φᵢ* is an index of a row of the matrix 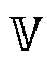 , which has a last non-zero element in column *i*, wherein 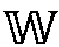 is a precoding matrix, and wherein ***A*** is defined as follows: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wherein ${A}_{{m}_{h}} = {\left(\begin{matrix}1 & 0 \\ 1 & 1\end{matrix}\right)}^{⊗ {m}_{h}} ,$ and wherein *Q*^{⊗*m*} denotes the *m*-times Kronecker product of a matrix *Q* with itself.

In an embodiment, similarly to the processor 102a, the processor 104a of the decoding apparatus 104 is configured to decode the codeword *c* using a *C(n, k, d)* code, wherein the code *C*(*n,k,d*) has a length *n* and a minimum distance *d*, wherein *n* = 2^{*m*₁} + ··· + 2*^{mₛ}*, wherein *mₕ* > *m*_{*h*+1}, *h* = 1,...,*s*, is an integer number, wherein: $c = u A ,$ wherein *uᵢ* = *xⱼ,* 0 ≤ *j* < *k* - 1, wherein *x* is data of dimension *k,* if *i* ∉ *F,* wherein *F* is a set of *n* - *k* frozen bit indices of the code *C(n, k, d)* and 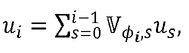 if *i* ∈ *F,* wherein 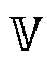 is a constraint matrix given by a solution of the equation: 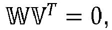 wherein *φᵢ* is an index of a row of the matrix 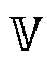 , which has a last non-zero element in column *i*, wherein 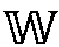 is a precoding matrix, and wherein ***A*** is defined as follows: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wherein ${A}_{{m}_{h}} = {\left(\begin{matrix}1 & 0 \\ 1 & 1\end{matrix}\right)}^{⊗ {m}_{h}} ,$ and wherein *Q*^{⊗*m*} denotes the *m*-times Kronecker product of a matrix *Q* with itself.

The communication channel 110 can be a wired or a wireless communication channel.

In an embodiment, the processor 102a can be configured to generate the constraint matrix 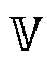 on the basis of the following steps:
1^{st} step: construct generator matrices ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right)$ of nested extended primitive narrow-sense BCH codes *Cᵢⱼ*(2*^{mi}*,*K_{i,j},dᵢⱼ*)*,* 0 ≤ *j* < *τᵢ,* wherein *G*^{(*i,j*)} is a *k_{i,j}* × 2*^{mᵢ}* matrix, ${K}_{i , j} = {\sum }_{s = 0}^{j} {k}_{i , s} ,$ and define the corresponding precoding matrices of *G*^{(*i,j*)} as: ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}}$ and ${W}^{\left(i, j\right)} = {G}^{\left(i, j\right)} {\left(\begin{matrix}1 & 0 \\ 1 & 1\end{matrix}\right)}^{⊗ {m}_{i}} ,$ wherein an index of a column where the *p*^{th} row of the matrix *W̃*^{(*i*,*τᵢ*-1)} starts is defined by: ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t , 0 \leq p < {2}^{{m}_{i}} .$ In an embodiment, it can be assumed that for any *i* all *l_{i,p}* are distinct and, in general, the integer number *τᵢ* is equal to the number of irreducible polynomials of degree *M,* wherein M represents the number of divisors of *mᵢ.*
2^{nd} step: apply elementary row operations to *W̃*^{(*i,j*)} in order to ensure that all rows start in distinct columns, while preserving the nested structure of the matrices *W̃*^{(*i,j*)}.
3^{rd} step: select rows of matrices *W̃*^{(*i,j*)}: *d_{i,j}* ≥ *d,* and put them into the *i*-th column of a precoding matrix 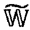 , wherein the precoding matrix 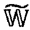 is a block matrix.
4^{th} step: select rows of matrices *W̃*^{(*i,j*)}: *d* > *d_{i,j}* ≥ *d* - *ε* for some *ε* > 0, put them into the *i-*th column of the precoding matrix 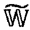 . For every such a row, select a row of a matrix *W̃*^{(*i',j'*)}, *i'* > *i, d_{i',j'}* ≥ *ε*, which has not been selected in the previous step, and put it into the same row of matrix 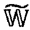 in column *i'*. Summarizing, the constructed precoding matrix 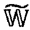 is given by: 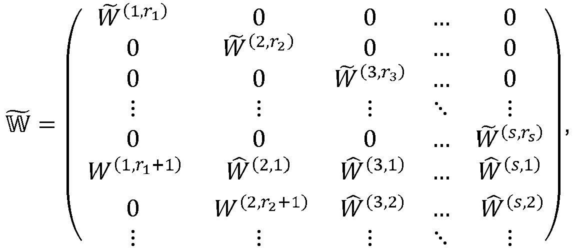 wherein ${r}_{i} = {max}_{j : {d}_{ij} \geq d} j$ is an index of a largest e-BCH code of length 2*^{mᵢ}* with minimum distance *d* and *δᵢ* = *d* - *d*_{*i*,*rᵢ*+1} is the minimum distance difference of the next largest e-BCH code. The matrices *Ŵ*^{(*i,j*)} consist of some rows of matrix *W̃*^{(***i***,*τⱼ*)} and zero rows, wherein ${τ}_{j} = {max}_{s : {d}_{i , s} \geq {δ}_{j}} s ,$ so that for any *s* there is at most one block *i* with non-zero row ${\hat{W}}_{s , _}^{\left(i, j\right)} .$
5^{th} step: keep *k* rows of matrix 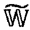 which start in column *l_{i,p}* of block *i* with the smallest P*_{mᵢ,lᵢ,p},* where P*_{m,i}* is the error probability in a bit subchannel ${W}_{m}^{\left(i\right)} \left({y}_{0}^{{2}^{m} - 1},{u}_{0}^{i - 1} |{u}_{i}\right) ,$ wherein ${y}_{0}^{{2}^{m} - 1} = {y}_{0} … {y}_{{2}^{m} - 1}$ denotes 2*^{m}* - 1 noisy symbols of the codeword c after a transmission over the communication channel 110. Let 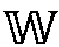 be the obtained matrix.
6^{th} step: obtain 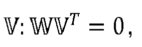 use Gaussian elimination to ensure that rows of 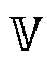 end in distinct columns *jᵢ,* 0 ≤ *i* < *n* - *k* and define the set of (dynamic) frozen bit indices as *F* = {*jᵢ,* 0 ≤ *i* < *n* - *k*}.

In order to illustrate the above described steps to generate the constraint matrix 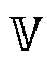 , the construction of an exemplary (24,11,6) code on the basis of chained polar subcodes is considered. In this case, the code has dimension *n* = 24, which can also be written as 24 = 2⁴ + 2³, so that *m*₀ = 4, *m*₁ = 3. In figures 1a and 1b, the nested generator matrices *G*^{(*i,j*)}, *i* = 0,1 and *j* = 1,2,3, of the corresponding extended BCH codes *Cᵢⱼ* are shown, wherein *d*_{0,0} = 16, *d*_{0,1} = 8, *d*_{0,2} = 6, *d*_{0,3} = 4, *d*_{1,0} = 8, *d*_{1,1} = 4, *d*_{1,2} = 2. By multiplying the matrices *G*^{(*i,j*)} shown in figures 1a and 1b by the matrices ${A}_{{m}_{i}} = {\left(\begin{matrix}1 & 0 \\ 1 & 1\end{matrix}\right)}^{⊗ {m}_{i}} ,$ and by applying elementary row operations, the corresponding precoding matrices *W*^{(*i,j*)} can be obtained, as shown in figures 1c and 1d. Combining the precoding matrices *W*^{(*i,j*)} with *ε* = 2, the precoding matrix 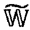 of the parent code can be obtained as shown in figure 1e. In the case of a binary erasure channel having erasure probability 0.5, the error probabilities in bit subchannels are for instance: 0.499,0.496,0.492,0.386,0.48,0.32,0.26,0.5e-1,0.44,0.23,0.17,0.18e-1,0.11, 0.7e-2, 0.38e-2, 0.76e-5; 0.498, 0.44, 0.40, 0.15, 0.34, 0.09, 0.06, 0.0019.

Since the 6^{th} row of the matrix 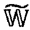 starts in column 3, which corresponds to a subchannel with the highest error probability 0.386, it can be eliminated. Therefore, a precoding matrix 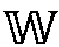 for the (24,11,6) code based on chained polar subcodes can be obtained as shown in figure 1f. Finally, the corresponding constraint matrix 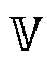 can be obtained as shown in figure 1g.

In another embodiment the processor 102a can be configured to construct the (*n* - *k*) × *n* matrix 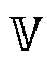 , according to the following steps:
1^{st} step: set the rows of 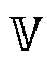 to distinct vectors of weight 1, containing 1 in columns *l_{i,p}* of block *i* with the highest P_{*mᵢ*,***l**ᵢ,p*}; and
2^{nd} step: put arbitrary binary values into columns *j* < *l_{i,p}* of at most two blocks *i,* for each of the last *ρ* rows of 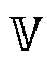 .

In an embodiment, the binary values can be obtained by a pseudo-random number generator (PRNG), such as a linear feedback shift register. This has the advantage that the code can be specified in a compact way by providing just the parameters and seed value of the PRNG. Furthermore, the matrix 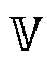 constructed according to the above mentioned steps has the advantage of providing chained polar subcodes which have a high performance.

Once the matrices 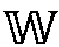 and 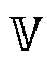 are available, in another embodiment, the processor 102a can further be configured to encode the data *x* of dimension *k* into the codeword *c* according to the following equation:

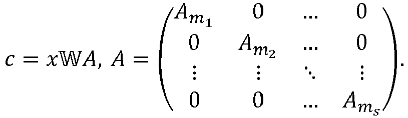

Furthermore, once the codeword c is encoded, it can be sent to the decoding apparatus 104 via the communication channel 110. However, after the transmission over the communication channel 110, the *n* symbols of the codeword *c* are affected by noise and they result in noisy symbols ${y}_{0}^{n - 1} = {y}_{0} … {y}_{n - 1} ,$ therefore a method is needed in order to recover the correct symbols of the codeword *c.*

In an embodiment, the processor 104a of the decoding apparatus 104 can be configured to recover the codeword *c* using a generalized successive cancellation algorithm and its list or sequential extensions on the basis of the following equations: 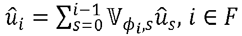 and ${û}_{i} = arg {max}_{{u}_{i}} {W}_{{μ}_{i}}^{\left(i mod {2}^{{μ}_{i}}\right)} \left({y}_{{t}_{i}}^{{2}^{{μ}_{i}} + {t}_{i} - 1} , {û}_{{t}_{i}}^{i - 1} |{u}_{i}\right) ,$ *i* ∉ *F* wherein *µᵢ* = └log₂(2^{┌log₂*n*┐} - *i*)┘ and *tᵢ* = 2^{┌log₂*n*┐} - 2^{*µᵢ*+1}.

This decoding method can also be extended to obtain list and sequential successive cancellation methods similar to the ones presented in the aforementioned works by Tal and Vardy and Miloslavskaya and Trifonov.

In an embodiment the order to obtain the symbol *ûᵢ* can be rearranged on the basis of the following rules:
a. If *µ*_{*i*₁} = *µ*_{*i*₂} and *i*₁ < *i*₂, then *û*_{*i*₁} is calculated before *û*_{*i*₂}; and
b. If *i* ∈ *F*, then 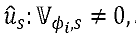 *s* < *i,* is calculated before *ûᵢ.*
Rearranging the detection order of symbols *ûᵢ* has the advantage that it can lead to an improved performance of list and sequential successive cancellation algorithms.

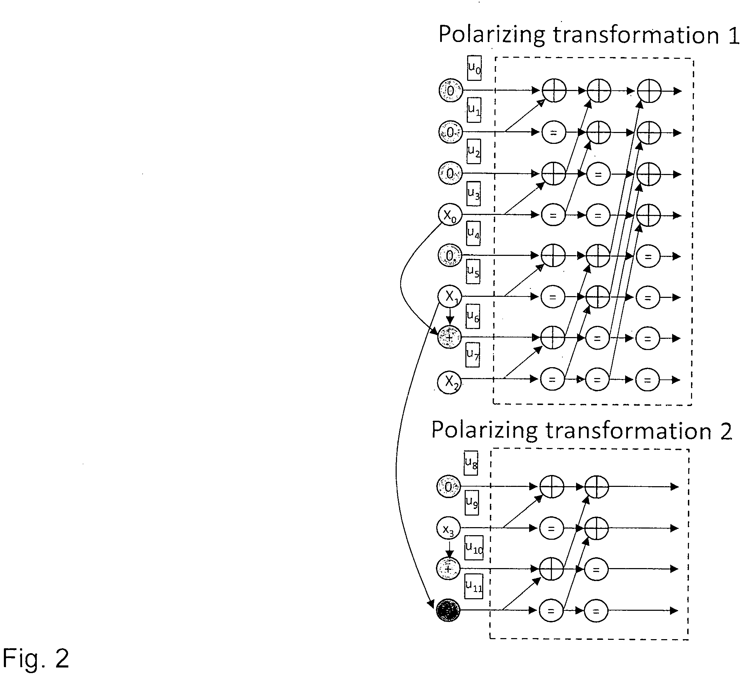

Figure 2 shows a schematic diagram of a structure of an encoding apparatus 102 for a code based on chained polar subcode according to an embodiment. In this embodiment, the code has a length *n* = 12 = 2³ + 2² and it includes two polarizing transformations: *A*_{*m*₁}, *m*₁ = 3, (polarizing transformation 1) of size 8 and *A*_{*m*₂}, *m*₂ = 2, (polarizing transformation 2) of size 4. The data *x* of dimension 4 to be encoded is represented by the four symbols *x*₀,*x*₁,*x*₂,*x*₃, which are mapped onto symbols *u*₃,*u*₅,*u*₇,*u*₉. The set of frozen bit symbols is represented by *u*₀,*u*₁,*u*₂,*u*₄,*u*₆,*u*₈,*u*₁₀*,u*₁₁. In an embodiment, the processor 102a of the encoding apparatus 102 can be configured to calculate symbols *u*₆ and *u*₁₀ as a function of some linear combinations of other input symbols of the corresponding polarizing transformations as shown in figure 2. Furthermore, the processor 102a can be configured to calculate the input symbol *u*₁₁ of the polarizing transformation 2 as a function of an input symbol of the polarizing transformation 1. Moreover, the structure of the freezing and cross-coding constraints can be realized in such a way that the obtained code has sufficiently high minimum distance and it can be decoded in an efficient way by a possible generalization or modification of the successive cancellation algorithm.

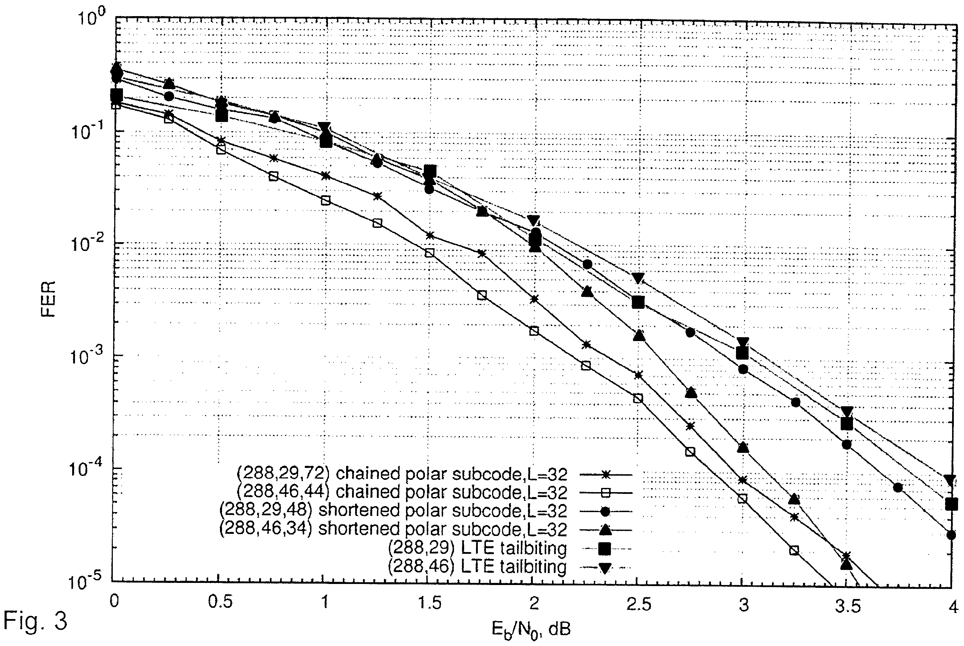

Figure 3 shows a frame error rate (FER) of different codes as a function of a signal-to-noise ratio (*E_{b}*/*N*₀) in dB according to an embodiment. As it is shown in figure 3, the performance of codes based on chained polar subcodes under a sequential decoding algorithm can significantly be improved compared to the performance of shortened polar subcodes, turbo codes and convolutional LTE tailbiting codes. In particular, codes based on chained polar subcodes can provide up to 0.3-0.7 dB power gain compared to shortened polar subcodes.

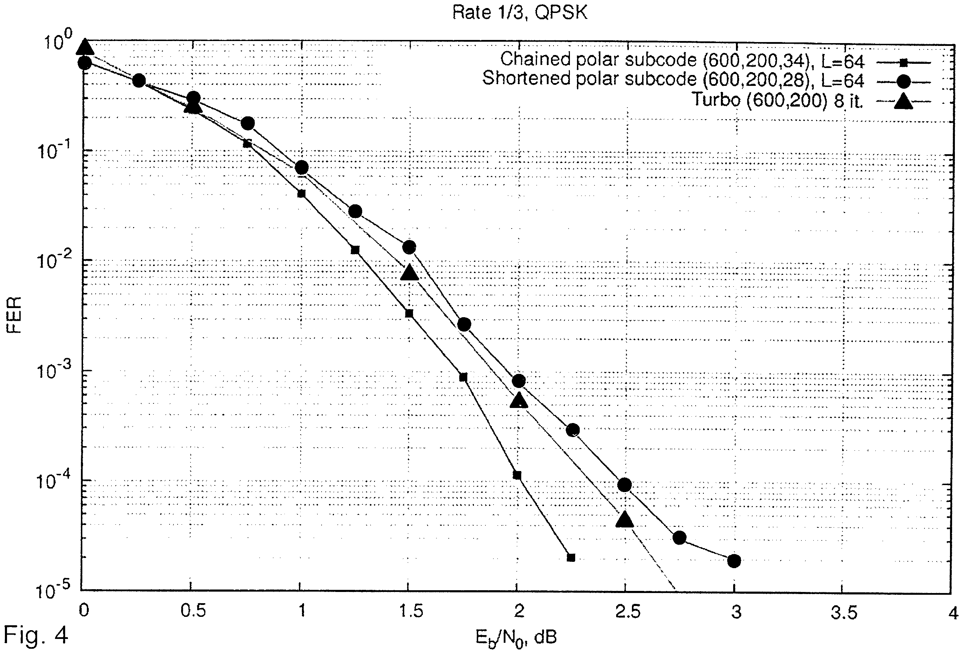

Figure 4 shows a frame error rate (FER) of different codes as a function of a signal-to-noise ratio (*E_{b}*/*N*₀) in dB according to an embodiment. Analogously to figure 3, in this case as well, the performance of codes based on chained polar subcodes is significantly improved compared to the performance of shortened polar subcodes and turbo codes.

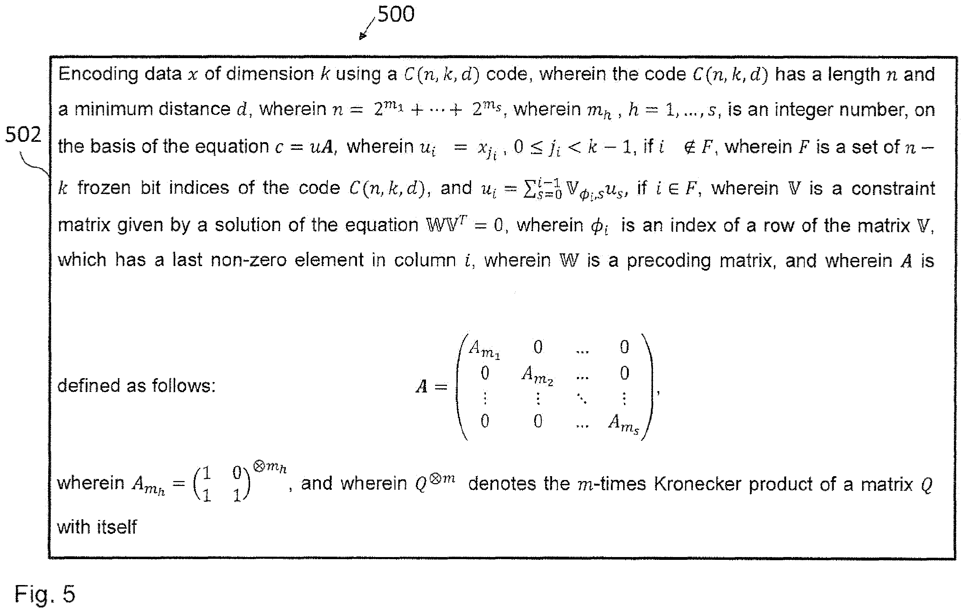

Figure 5 shows a schematic diagram of a method 500 for encoding data *x* of dimension *k* into a codeword *c* of length *n* according to an embodiment. The method 500 comprises the step of:
encoding 502 the data *x* using a *C*(*n,k,d*) code, wherein the code *C*(*n,k,d*) has a length *n* and a minimum distance *d*, wherein *n* = 2^{*m*₁} + ...+ 2*^{mₛ}*, wherein *mₕ*, *h* = 1,...,*s,* is an integer number, on the basis of the equation: $c = u A ,$ wherein *uᵢ* = *x_{jᵢ}*, 0 ≤ *jᵢ < k* - 1, if *i* ∉ *F*, wherein *F* is a set of *n* - *k* frozen bit indices of the code *C*(*n,k,d*), and 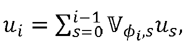 if *i* ∈ *F*, wherein 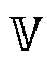 is a constraint matrix given by a solution of the equation: 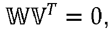 wherein *φᵢ* is an index of a row of the matrix 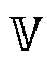 , which has a last non-zero element in column *i*, wherein 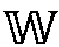 is a precoding matrix, and wherein ***A*** is defined as follows: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wherein ${A}_{{m}_{h}} = {\left(\begin{matrix}1 & 0 \\ 1 & 1\end{matrix}\right)}^{⊗ {m}_{h}} ,$ and wherein *Q*^{⊗*m*} denotes the *m*-times Kronecker product of a matrix *Q* with itself.

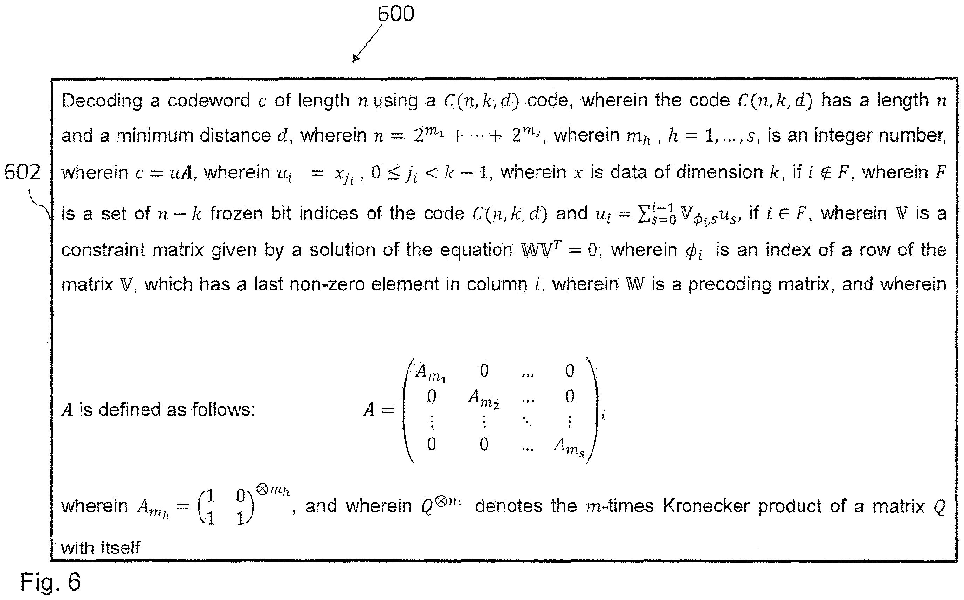

Figure 6 shows a schematic diagram of a method 600 for decoding a codeword *c* of length *n* according to an embodiment. The method 600 comprises the step of:
decoding 602 the codeword c using a *C*(*n,k,d*) code, wherein the code *C*(*n,k,d*) has a length *n* and a minimum distance *d*, wherein *n* = 2^{*m*₁} + ···+ 2*^{mₛ}*, wherein *mₕ* , *h* = 1,...,*s*, is an integer number, wherein: $c = u A ,$ wherein *uᵢ* = *x_{jᵢ}*, 0 ≤ *jᵢ < k* - 1, wherein *x* is data of dimension *k,* if *i* ∉ *F*, wherein *F* is a set of *n* - *k* frozen bit indices of the code *C*(*n,k,d*) and 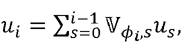 if *i* ∈ *F*, wherein 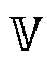 is a constraint matrix given by a solution of the equation: 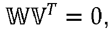 wherein *φᵢ* is an index of a row of the matrix 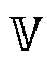 , which has a last non-zero element in column *i*, wherein 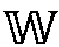 is a precoding matrix, and wherein ***A*** is defined as follows: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wherein ${A}_{{m}_{h}} = {\left(\begin{matrix}1 & 0 \\ 1 & 1\end{matrix}\right)}^{⊗ {m}_{h}} ,$ and wherein *Q*^{⊗*m*} denotes the *m*-times Kronecker product of a matrix *Q* with itself.

While a particular feature or aspect of the disclosure may have been disclosed with respect to only one of several implementations or embodiments, such feature or aspect may be combined with one or more other features or aspects of the other implementations or embodiments as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.
Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art will readily recognize that there are numerous applications of the invention beyond those described herein. While the present invention has been described with reference to one or more particular embodiments, those skilled in the art will recognize that many changes may be made thereto without departing from the scope of the present invention. It is therefore to be understood that within the scope of the appended claims the invention may be practiced otherwise than as specifically described herein.

## Claims

1. An encoding apparatus (102) for encoding data *x* of dimension *k* into a codeword c of length *n*, wherein the encoding apparatus (102) comprises:
a processor (102a) configured to encode the data *x* using a *C*(*n,k,d*) code, wherein the code *C*(*n,k,d*) has a length *n* and a minimum distance *d,* wherein *n* = 2^{*m*₁} + ··· + 2*^{mₛ}*, wherein *mₕ*, *h* = 1, ..., *s*, is an integer number, and s > 1, on the basis of the equation: $c = u A ,$ wherein *uᵢ* = *x_{jᵢ},* 0 ≤ *jᵢ* < *k* - 1, if *i* ∉ *F,* wherein *F* is a set of *n* - *k* frozen bit indices of the code *C*(*n,k,d*), and 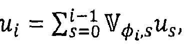 if *i* ∈ *F*, wherein 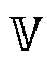 is a constraint matrix given by a solution of the equation: 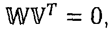 wherein *φᵢ* is an index of a row of the matrix 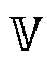 , which has a last non-zero element in column *i*, wherein 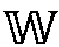 is a precoding matrix, and wherein ***A*** is defined as follows: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wherein ${A}_{{m}_{h}} = {\left(\begin{matrix}1 & 0 \\ 1 & 1\end{matrix}\right)}^{⊗ {m}_{h}} ,$ and wherein *Q*^{⊗*m*} denotes the *m*-times Kronecker product of a matrix *Q* with itself;
wherein the processor (102a) is further configured to construct the code *C*(*n,k,d*) on the basis of a plurality of nested linear block codes *Cᵢⱼ*(2*^{mᵢ},K_{i,j}*,*dᵢⱼ*), *K*_{*i,j*+1} > *K_{i,j},* 0 ≤ *j* < *τᵢ,* wherein *τᵢ* is a positive integer, wherein a generator matrix of *Cᵢⱼ*(2*^{mᵢ}*,*K_{i,j},dᵢⱼ*) is given by the equation: ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ wherein *G*^{(*i,j*)} is a *k_{i,j}* × 2*^{mᵢ}* matrix, ${K}_{i , j} = {\sum }_{s = 0}^{j} {k}_{i , s} ,$ wherein a precoding matrix of *G*^{(*i,j*)} is defined by ${W}^{\left(i, j\right)} = {G}^{\left(i, j\right)} {\left(\begin{matrix}1 & 0 \\ 1 & 1\end{matrix}\right)}^{⊗ {m}_{i}}$ wherein a precoding matrix of *G̃*^{(*i,j*)} is defined by ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}} ,$ wherein an index *l_{i,p}* of a column, where a *p*-th row of the matrix *W̃*(^{*i,τᵢ* -1)} starts, is defined by the equation ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mᵢ}*, and to construct the precoding matrix 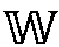 as a block matrix, wherein the blocks of the precoding matrix 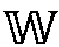 consist of selected rows of the matrices *W̃*^{(*i,j*)}.

2. The encoding apparatus (102) of claim 1, wherein the plurality of nested linear block codes *Cᵢⱼ*(2*^{mᵢ},K_{i,j},dᵢⱼ*) are extended Bose-Chaudhuri-Hocquenghem (e-BCH) codes.

3. The encoding apparatus (102) of any one of the preceding claims, wherein the processor (102a) is further configured to construct a precoding matrix 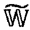 of the code *C*(*n,k,d*) as follows: 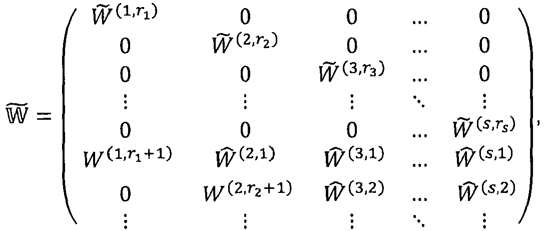 wherein *rᵢ* = max_{*j*:*dᵢⱼ*≥}*_{d} j* is an index of a largest e-BCH code of length 2*^{mᵢ}* having a minimum distance of at least *d* and wherein *Ŵ*^{(*i,j*)} consist of some rows of matrix *Ŵ*^{(***i***,*τⱼ*)} and zero rows, wherein *τⱼ* = max_{*s*:*d_{i,s}*≥}*_{δj} s*, so that for any s there is at most one block *i* with non-zero row ${\hat{W}}_{s , _}^{\left(i, j\right)} .$

4. The encoding apparatus (102) of claim 3, wherein the processor (102a) is further configured to construct the matrix *Ŵ*^{(*i,j*)} by means of rows of the matrix *W̃*^{(***i***,*τⱼ*)} having the smallest value of P*_{mᵢ,**l**ᵢ,p}*, wherein P*_{m,i}* is an error probability in a bit subchannel ${W}_{m}^{\left(i\right)} \left({y}_{0}^{{2}^{m} - 1},{u}_{0}^{i - 1} |{u}_{i}\right) ,$ wherein ${y}_{0}^{{2}^{m} - 1} = {y}_{0} … {y}_{{2}^{m} - 1}$ denotes 2*^{m}* - 1 noisy symbols of the codeword *c* after a transmission over a communication channel (110).

5. The encoding apparatus (102) of any one of the preceding claims, wherein the processor (102a) is further configured to construct a first plurality of *t* rows of the matrix 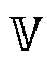 in such a way that the last non-zero elements in the first plurality of *t* rows are located in distinct positions *j, j* ≥ *j*₀ for some integer *j*₀, to construct elements of the first plurality of *t* rows located in columns having an index *z* < *j* by means of a pseudorandom number generator, and to construct a second plurality of *n* - *k* - *t* rows of matrix 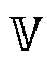 as distinct weight-one rows.

6. The encoding apparatus (102) of claim 5, wherein the pseudorandom number generator is a linear feedback shift register.

7. The encoding apparatus (102) of any one of claims 3 and 4, wherein the processor (102a) is further configured to arrange the rows of the matrix *W*^{(*i*,*rᵢ*+1)} or *Ŵ*^{(*j*,*i*)} in an ascending order of the values *l_{i,p}* and *l*_{*j*,*p*} respectively.

8. The encoding apparatus (102) of any one of claims 3, 4 and 7 wherein the processor (102a) is configured to construct the matrix 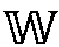 based on *k* rows of the matrix 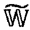 with the smallest values of *l_{i,p}.*

9. A method (500) for encoding data *x* of dimension *k* into a codeword *c* of length *n*, wherein the method comprises the step of:
encoding (502) the data *x* using a *C*(*n,k,d*) code, wherein the code C(*n*,*k,d*) has a length *n* and a minimum distance *d,* wherein *n* = 2^{*m*₁} + ··· + 2*^{mₛ}*, wherein *mₕ, h* = 1,...,*s,* is an integer number, and s > 1, on the basis of the equation: $c = u A ,$ wherein *uᵢ* = *x_{jᵢ}* , 0 ≤ *jᵢ < k* - 1, if *i* ∉ *F*, wherein *F* is a set of *n* - *k* frozen bit indices of the code C(*n*,*k,d*), and 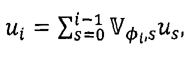 if *i* ∈ *F*, wherein 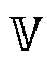 is a constraint matrix given by a solution of the equation: 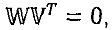 wherein *φᵢ* is an index of a row of the matrix 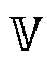 , which has a last non-zero element in column *i*, wherein 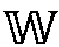 is a precoding matrix, and wherein ***A*** is defined as follows: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wherein ${A}_{{m}_{h}} = {\left(\begin{matrix}1 & 0 \\ 1 & 1\end{matrix}\right)}^{⊗ {m}_{h}} ,$ and wherein *Q*^{⊗*m*} denotes the *m*-times Kronecker product of a matrix *Q* with itself;
wherein the method further comprises constructing the code *C*(*n,k,d*) on the basis of a plurality of nested linear block codes *Cᵢⱼ*(2*^{mᵢ}*,*K_{i,j},dᵢⱼ*), *K*_{*i,j*+1} > *K_{i,j}* 0 ≤ *j* < *τᵢ,* wherein *τᵢ* is a positive integer, wherein a generator matrix of *Cᵢⱼ*(2*^{mᵢ}*,*K_{i,j},dᵢⱼ*) is given by the equation: ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ wherein *G*^{(*i,j*)} is a *k_{i,j}* × 2*^{mᵢ}* matrix, ${K}_{i , j} = {\sum }_{s = 0}^{j} {k}_{i , s} ,$ wherein a precoding matrix of *G*^{(*i,j*)} is defined by ${W}^{\left(i, j\right)} = {G}^{\left(i, j\right)} {\left(\begin{matrix}1 & 0 \\ 1 & 1\end{matrix}\right)}^{⊗ {m}_{i}} ,$ wherein a precoding matrix of *G̃*^{(*i,j*)} is defined by ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}} ,$ wherein an index *l_{i,p}* of a column, where a *p*-th row of the matrix *W̃*^{(*i,τᵢ* -1)} starts, is defined by the equation ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mᵢ}*, and to construct the precoding matrix 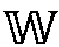 as a block matrix, wherein the blocks of the precoding matrix 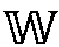 consist of selected rows of the matrices *W̃*^{(*i,j*)}.

10. A decoding apparatus (104) for decoding a codeword c of length *n*, wherein the decoding apparatus (104) comprises:
a processor (104a) configured to decode the codeword *c* using a *C*(*n,k,d*) code, wherein the code *C*(*n,k,d*) has a length *n* and a minimum distance *d,* wherein *n* = 2^{*m*₁} + ··· + 2*^{mₛ}*, wherein *mₕ*, *h* = 1, ..., *s*, is an integer number, and s > 1, wherein: $c = u A ,$ wherein *uᵢ* = *x_{jᵢ}*, 0 ≤ *jᵢ* < *k* - 1, wherein *x* is data of dimension *k,* if *i* ∉ *F*, wherein *F* is a set of *n - k* frozen bit indices of the code *C*(*n,k,d*) and 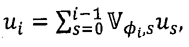 if *i* ∈ *F*, wherein 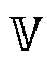 is a constraint matrix given by a solution of the equation: 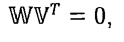 wherein *φᵢ* is an index of a row of the matrix 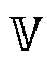 , which has a last non-zero element in column *i*, wherein 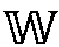 is a precoding matrix, and wherein ***A*** is defined as follows: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wherein ${A}_{{m}_{h}} = {\left(\begin{matrix}1 & 0 \\ 1 & 1\end{matrix}\right)}^{⊗ {m}_{h}} ,$ and wherein *Q*^{⊗*m*} denotes the *m*-times Kronecker product of a matrix *Q* with itself;
wherein the processor (104a) is further configured to construct the code *C*(*n,k,d*) on the basis of a plurality of nested linear block codes *Cᵢⱼ*(2*^{mᵢ},K_{i,j},dᵢⱼ*), *K*_{*i,j*+1} > *K_{i,j},* 0 ≤ *j* < *τᵢ,* wherein *τᵢ* is a positive integer, wherein a generator matrix of *Cᵢⱼ*(2*^{mᵢ}*,*K_{i,j},dᵢⱼ*) is given by the equation: ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ wherein *G*^{(*i,j*)} is a *k_{i,j}* × 2*^{mᵢ}* matrix, ${K}_{i , j} = {\sum }_{s = 0}^{j} {k}_{i , s} ,$ wherein a precoding matrix of *G*^{(*i,j*)} is defined by ${W}^{\left(i, j\right)} = {G}^{\left(i, j\right)} {\left(\begin{matrix}1 & 0 \\ 1 & 1\end{matrix}\right)}^{⊗ {m}_{i}} ,$ wherein a precoding matrix of *G̃*^{(*i,j*)} is defined by ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}} ,$ wherein an index *l_{i,p}* of a column, where a *p*-th row of the matrix *W̃*^{(*i,τᵢ* -1)} starts, is defined by the equation ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mᵢ},* and to construct the precoding matrix 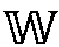 as a block matrix, wherein the blocks of the precoding matrix 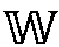 consist of selected rows of the matrices *W̃*^{(*i,j*)}.

11. The decoding apparatus (104) of claim 10, wherein the processor (104a) is further configured to decode the codeword *c* by means of a generalization of a successive cancellation algorithm.

12. The decoding apparatus (104) of claim 11, wherein the processor (104a) is further configured to compute u by means of the following equations: 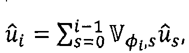 if *i* ∈ *F* and ${û}_{i} = {argmax}_{{u}_{i}} {W}_{{μ}_{i}}^{\left(i mod {2}^{{μ}_{i}}\right)} \left({y}_{{t}_{i}}^{{2}^{{μ}_{i}} + {t}_{i} - 1} , {û}_{{t}_{i}}^{i - 1} |{u}_{i}\right) ,$ if *i* ∉ *F*
wherein *φᵢ* is an index of a row of the matrix 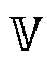 , which has a last non-zero element in column *i*, wherein ${y}_{0}^{n - 1} = {y}_{0} … {y}_{n - 1}$ denotes *n* noisy symbols of the codeword *c* after a transmission over a communication channel 110 to the decoding apparatus, *µᵢ* = └log₂(2^{┌log₂*n*┐} - *i*)┘, and *tᵢ* = 2^{┌log2*n*┐} - 2^{*µᵢ*+1}.

13. The decoding apparatus (104) of claim 12, wherein the processor (104a) is further configured to compute *û*_{*i*₁} before *û*_{*i*₂}, if *µ*_{*i*₁} = *µ*_{*i*₂} and *i*₁ < *i*₂, and to compute *ûₛ*: 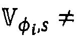 0, *s* < *i*, before *ûᵢ,* if *i* ∈ *F.*

14. A method (600) for decoding a codeword *c* of length *n*, wherein the method comprises the step of:
decoding (602) the codeword *c* using a *C*(*n,k,d*) code, wherein the code *C*(*n,k,d*) has a length *n* and a minimum distance *d,* wherein *n* = 2^{*m*₁} + ··· + 2*^{mₛ}*, wherein *mₕ*, *h* = 1, ..., *s*, is an integer number, and s > 1, wherein: $c = u A ,$ wherein *uᵢ* = *x_{jᵢ},* 0 ≤ *jᵢ* < *k* - 1, wherein *x* is data of dimension *k*, if *i* ∉ *F,* wherein *F* is a set of *n - k* frozen bit indices of the code *C*(*n,k,d*) and 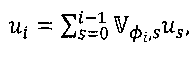 if *i* ∈ *F,* wherein 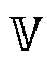 is a constraint matrix given by a solution of the equation: 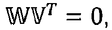 wherein *φᵢ* is an index of a row of the matrix 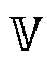 , which has a last non-zero element in column *i*, wherein 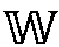 is a precoding matrix, and wherein ***A*** is defined as follows: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wherein ${A}_{{m}_{h}} = {\left(\begin{matrix}1 & 0 \\ 1 & 1\end{matrix}\right)}^{⊗ {m}_{h}} ,$ and wherein *Q*^{⊗*m*} denotes the *m*-times Kronecker product of a matrix *Q* with itself;
wherein the method further comprises constructing the code *C*(*n,k,d*) on the basis of a plurality of nested linear block codes *Cᵢⱼ*(2*^{mᵢ}*,*K_{i,j},dᵢⱼ*), *K*_{*i,j*+1} > *K_{i,j},* 0 ≤ *j* < *τᵢ,* wherein *τᵢ* is a positive integer, wherein a generator matrix of *Cᵢⱼ*(2*^{mᵢ},K_{i,j},dᵢⱼ*) is given by the equation: ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ wherein *G*^{(*i,j*)} is a *k_{i,j}* × 2*^{mᵢ}* matrix, ${K}_{i , j} = {\sum }_{s = 0}^{j} {k}_{i , s} ,$ wherein a precoding matrix of *G*^{(*i,j*)} is defined by ${W}^{\left(i, j\right)} = {G}^{\left(i, j\right)} {\left(\begin{matrix}1 & 0 \\ 1 & 1\end{matrix}\right)}^{⊗ {m}_{i}} ,$ wherein a precoding matrix of *G̃*^{(*i,j*)} is defined by ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}} ,$ wherein an index *l_{i,p}* of a column, where a *p*-th row of the matrix *W̃*^{(*i*,*τᵢ* -1)} starts, is defined by the equation ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mᵢ}*, and to construct the precoding matrix 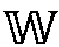 as a block matrix, wherein the blocks of the precoding matrix 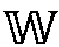 consist of selected rows of the matrices *W̃*^{(*i,j*)}.

## Patentansprüche

1. Codierungseinrichtung (102) zum Codieren von Daten *x* einer Dimension *k* in ein Codewort c der Länge *n*, wobei die Codierungseinrichtung (102) Folgendes umfasst:
einen Prozessor (102a), der zum Codieren der Daten *x* unter Verwendung eines *C*(*n*,*k,d*)-Codes, wobei der Code *C*(*n,k,d*) eine Länge *n* und eine minimale Distanz *d* aufweist, wobei *n* = 2^{*m*₁} + ··· + 2*^{mₛ}* gilt, wobei *mₕ, h* = 1, ..., *s* eine ganze Zahl ist und s > 1 gilt, basierend auf der folgenden Gleichung konfiguriert ist: $c = uA ,$ wobei *uᵢ* = *x_{jᵢ}, 0* ≤ *jᵢ < k* - 1 gilt, falls *i* ∉ *F* gilt, wobei *F* ein Satz aus *n* - *k* eingefrorenen Bitindices des Codes *C*(*n*,*k,d*) ist, und 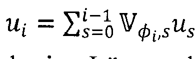 gilt, falls *i* ∈ *F* gilt, wobei 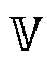 eine Bedingungsmatrix ist, die durch eine Lösung der folgenden Gleichung gegeben ist: 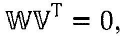 wobei *φᵢ* ein Index einer Zeile der Matrix 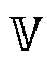 ist, die ein letztes Element ungleich Null in der Spalte *i* aufweist, wobei 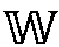 eine Vorcodierungsmatrix ist und wobei *A* wie folgt definiert ist: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wobei ${A}_{{m}_{h}} = {\left(\begin{matrix}1 & 0 \\ 1 & 1\end{matrix}\right)}^{⊗ {m}_{h}}$ gilt und wobei *Q*^{⊗*m*} das *m*-te Kronecker-Produkt einer Matrix Q mit sich selbst bezeichnet,
wobei der Prozessor (102a) ferner konfiguriert ist zum Konstruieren des Codes *C*(*n,k,d*) basierend auf mehreren verschachtelten linearen Blockcodes *Cᵢⱼ*(2*^{mᵢ}*,*K_{i,j},dᵢⱼ*), *K*_{*i,j*+1} > *K_{i,j},* 0 ≤ *j* < *τᵢ,* wobei *τᵢ* eine positive ganze Zahl ist, wobei eine Generatormatrix von *Cᵢⱼ*(2*^{mᵢ},K_{i,j},dᵢⱼ*) durch die folgende Gleichung gegeben ist: ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ wobei *G*^{(*i,j*)} eine *k_{i,j}* × 2*^{mᵢ}* -Matrix ist, ${K}_{i , j} = {\sum }_{s = 0}^{j} {k}_{i , s}$ gilt, wobei eine Vorcodierungsmatrix von *G*^{(*i,j*)} durch ${W}^{\left(i, j\right)} = {G}^{\left(i, j\right)} {\left(\begin{matrix}1 & 0 \\ 1 & 1\end{matrix}\right)}^{⊗ {m}_{i}}$ definiert ist, wobei eine Vorcodierungsmatrix *G̃*^{(*i,j*)} durch ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}}$ definiert ist, wobei ein Index *l_{i,p}* einer Spalte, in der eine *p*-te Zeile der Matrix *W̃*^{(*i,τᵢ*-1)} startet, durch die Gleichung ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mᵢ}* definiert ist, und zum Konstruieren der Vorcodierungsmatrix 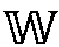 als eine Blockmatrix, wobei die Blöcke der Vorcodierungsmatrix 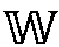 aus ausgewählten Zeilen der Matrizen *W̃*^{(*i,j*)} bestehen.

2. Codierungseinrichtung (102) nach Anspruch 1, wobei die mehreren verschachtelten linearen Blockcodes *Cᵢⱼ*(2*^{mᵢ}*,*K_{i,j},dᵢⱼ*) erweiterte Bose-Chaudhuri-Hocquenghem (e-BCH)-Codes sind.

3. Codierungseinrichtung (102) nach einem der vorhergehenden Ansprüche, wobei der Prozessor (102a) ferner zum Konstruieren einer Vorcodierungsmatrix 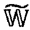 der Codierung *C*(*n,k,d*) wie folgt konfiguriert ist: 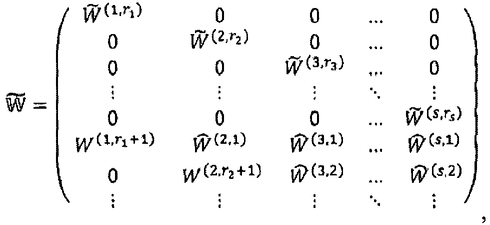 wobei *rᵢ* = *max*_{*j:d_{i,j}*≥}*_{d}j* ein Index eines größten e-BCH-Codes einer Länge 2*^{mᵢ}* mit einer minimalen Distanz von mindestens *d* ist und wobei *Ŵ*^{(*i,j*)} aus manchen Zeilen einer Matrix *W̃*^{(*i,τⱼ*)} und Nullzeilen besteht, wobei *τⱼ* = *max*_{*s:d_{i,s}*≥*δⱼ*}s gilt, so dass es für ein beliebiges *s* höchstens einen Block *i* mit einer Zeile ${\hat{W}}_{s , -}^{\left(i, j\right)}$ ungleich Null gibt.

4. Codierungseinrichtung (102) nach Anspruch 3, wobei der Prozessor (102a) ferner zum Konstruieren der Matrix *Ŵ*^{(*i,j*)} mittels Zeilen der Matrix *W̃*^{(*i,τⱼ*)} mit dem kleinsten Wert von *P_{mᵢ,lᵢ,p}* konfiguriert ist, wobei *P_{m,i}* eine Fehlerwahrscheinlichkeit in einem Bitsubkanal ${W}_{m}^{\left(i\right)} \left({y}_{0}^{2 m - 1} , {u}^{i - 1} _ 0 |{u}_{i}\right)$ ist, wobei ${y}_{0}^{{2}^{m} - 1} = {y}_{0} … {y}_{{2}^{m} - 1}$ 2*^{m}* - 1 rauschbehaftete Symbole des Codeworts *c* nach einer Übertragung über einen Kommunikationskanal (110) bezeichnet.

5. Codierungseinrichtung (102) nach einem der vorhergehenden Ansprüche, wobei der Prozessor (102a) ferner zum Konstruieren erster mehrerer *t* Zeilen der Matrix 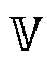 auf eine solche Weise konfiguriert ist, dass sich die letzten Elemente ungleich Null in den ersten mehreren *t* Zeilen an distinkten Positionen *j, j* ≥ *j*₀ für manche ganzen Zahlen *j*₀ befinden, um Elemente der ersten mehreren *t* Zeilen, die sich in Spalten mit einem Index *z* < *j* befinden, mittels eines Pseudozufallszahlengenerators zu konstruieren und zweite mehrere *n* - *k* - z Zeilen einer Matrix 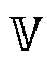 als distinkte Zeilen mit Gewicht Eins zu konstruieren.

6. Codierungseinrichtung (102) nach Anspruch 5, wobei der Pseudozufallszahlengenerator ein lineares Rückkopplungsschieberegister ist.

7. Codierungseinrichtung (102) nach einem der Ansprüche 3 und 4, wobei der Prozessor (102a) ferner zum Anordnen der Zeilen der Matrix *W*^{(*i*,*τᵢ*+1}) oder *Ŵ*^{(*j,i*)} in einer aufsteigenden Reihenfolge der Werte *l*_{*i*,*p*} bzw. *l_{j,p}* konfiguriert ist.

8. Codierungseinrichtung (102) nach einem der Ansprüche 3, 4 und 7, wobei der Prozessor (102a) zum Konstruieren der Matrix W basierend auf *k* Zeilen der Matrix 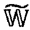 mit den kleinsten Werten von *l_{i,p}* konfiguriert ist.

9. Verfahren (500) zum Codieren von Daten *x* einer Dimension *k* in ein Codewort c der Länge n, wobei das Verfahren die folgenden Schritte umfasst:
Codieren (502) der Daten *x* unter Verwendung eines *C*(*n, k, d*) -Codes, wobei der Code *C*(*n, k, d)* eine Länge *n* und eine minimale Distanz d aufweist, wobei n = 2^{*m*₁} + ···+ 2*^{mₛ}* gilt, wobei *mₕ, h* = 1, ..., s eine ganze Zahl ist und s > 1 gilt, basierend auf der folgenden Gleichung: $c = uA ,$ wobei *uᵢ* = *xⱼᵢ,* 0 ≤ *jᵢ < k* - 1 gilt, falls *i* ∉ *F* gilt, wobei F ein Satz aus n - *k* eingefrorenen Bitindices des Codes *C(n, k, d)* ist und 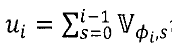 *u^{s}* gilt, falls *i* ∈ F gilt, wobei V eine Bedingungsmatrix ist, die durch eine Lösung der folgenden Gleichung gegeben ist: 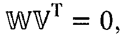 wobei *φᵢ* ein Index einer Zeile der Matrix 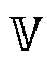 ist, die ein letztes Element ungleich Null in der Spalte i aufweist, wobei W eine Vorcodierungsmatrix ist und wobei *A* wie folgt definiert ist: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wobei ${A}_{{m}_{h}} = {\left(\begin{matrix}1 & 0 \\ 1 & 1\end{matrix}\right)}^{⊗ {m}_{h}}$ gilt und wobei *Q*^{⊗*m*} das *m*-te Kronecker-Produkt einer Matrix Q mit sich selbst bezeichnet; wobei das Verfahren ferner Folgendes umfasst: Konstruieren des Codes *C*(*n, k, d*) basierend auf mehreren verschachtelten linearen Blockcodes *Cᵢⱼ*(2*^{mᵢ}, K_{i,j}, dᵢⱼ*),*K*_{*i,j*+1} > *K_{i,j},* 0 ≤ j < *τᵢ*, wobei *τᵢ* eine positive ganze Zahl ist, wobei eine Generatormatrix von *Cᵢⱼ*(2*^{mᵢ}*, *K_{i,j}, dᵢⱼ*) durch die folgende Gleichung gegeben ist: ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ wobei *G*^{(*i,j*)} eine *k_{i,j}* × 2*^{mᵢ}* -Matrix ist, ${K}_{i , j} = {\sum }_{s = 0}^{j} {k}_{i , s}$ gilt, wobei eine Vorcodierungsmatrix von *G*^{(*i,j*)} durch ${W}^{\left(i, j\right)} = {G}^{\left(i, j\right)} {\left(\begin{matrix}1 & 0 \\ 1 & 1\end{matrix}\right)}^{⊗ {m}_{i}}$ definiert ist, wobei eine Vorcodierungsmatrix *G̃*^{(*i,j*)} durch ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}}$ definiert ist, wobei ein Index *l_{i,p}* einer Spalte, in der eine p-te Zeile der Matrix *W̃*^{(*i*,*τᵢ*-1)} startet, durch die Gleichung ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$*l_{i,p}* 0 ≤ *p* < 2*^{mᵢ}* definiert ist, und zum Konstruieren der Vorcodierungsmatrix W als eine Blockmatrix, wobei die Blöcke der Vorcodierungsmatrix W aus ausgewählten Zeilen der Matrizen *W̃*^{(*i,j*)} bestehen.

10. Decodierungseinrichtung (104) zum Decodieren eines Codeworts c der Länge n, wobei die Decodierungseinrichtung (104) Folgendes umfasst:
einen Prozessor (104a), der zum Decodieren des Codeworts c unter Verwendung eines *C(n, k,* d)-Codes konfiguriert ist, wobei der Code *C*(*n, k, d*) eine Länge *n* und eine minimale Distanz *d* aufweist, wobei *n* = 2^{*m*₁} + ···+ 2*^{mₛ}* gilt, wobei *mₕ, h* = 1, ...,*s* eine ganze Zahl ist und s > 1 gilt, wobei: $c = uA ,$ wobei *uᵢ* = *x_{jᵢ},* 0 ≤ *jᵢ < k* - 1 gilt, wobei *x* Daten der Dimension *k* sind, falls i ∉ *F* gilt, wobei F ein Satz aus *n* - *k* eingefrorenen Bitindices des Codes *C(n, k, d)* ist und 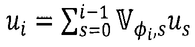 *uᵢ* gilt, falls i ∈ F gilt, wobei V eine Bedingungsmatrix ist, die durch eine Lösung der folgenden Gleichung gegeben ist: 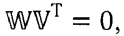 wobei *φᵢ* ein Index einer Zeile der Matrix 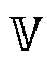 ist, die ein letztes Element ungleich Null in der Spalte *i* aufweist, wobei W eine Vorcodierungsmatrix ist und wobei *A* wie folgt definiert ist: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wobei ${A}_{{m}_{h}} = {\left(\begin{matrix}1 & 0 \\ 1 & 1\end{matrix}\right)}^{⊗ {m}_{h}}$ gilt und wobei *Q*^{⊗*m*} das *m*-te Kronecker-Produkt einer Matrix Q mit sich selbst bezeichnet,
wobei der Prozessor (104a) ferner konfiguriert ist zum Konstruieren des Codes *C*(*n, k, d*) basierend auf mehreren verschachtelten linearen Blockcodes *Cᵢⱼ*(2*^{mᵢ},K_{i,j},dᵢⱼ*), *K*_{*i,j*+1} *> K_{i,j},* 0 ≤ *j* < *τᵢ*, wobei *τᵢ* eine positive ganze Zahl ist, wobei eine Generatormatrix von *Cᵢⱼ*(2*^{mᵢ}, K_{i,j}, dᵢⱼ*) durch die folgende Gleichung gegeben ist: ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ wobei *G*^{(*i,j*)} eine *k_{i,j}* × 2*^{mᵢ}* -Matrix ist, ${K}_{i , j} = {\sum }_{s = 0}^{j} {k}_{i , s}$ gilt, wobei eine Vorcodierungsmatrix von *G*^{(*i,j*)} durch ${W}^{\left(i, j\right)} = {G}^{\left(i, j\right)} {\left(\begin{matrix}1 & 0 \\ 1 & 1\end{matrix}\right)}^{⊗ {m}_{i}}$ definiert ist, wobei eine Vorcodierungsmatrix *G̃*^{(*i,j*)} durch ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}}$ definiert ist, wobei ein Index *l*_{*i*,*p*} einer Spalte, in der eine p-te Zeile der Matrix *W̃*^{(*i*,*τᵢ*-1)} startet, durch die Gleichung ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$*l_{i,p}* 0 ≤ *p* < 2*^{mᵢ}* definiert ist, und zum Konstruieren der Vorcodierungsmatrix W als eine Blockmatrix, wobei die Blöcke der Vorcodierungsmatrix W aus ausgewählten Zeilen der Matrizen *W̃*^{(*i,j*)} bestehen.

11. Decodierungseinrichtung (104) nach Anspruch 10, wobei der Prozessor (104a) ferner zum Decodieren des Codeworts c mittels einer Verallgemeinerung eines Sukzessive-Aufhebung-Algorithmus konfiguriert ist.

12. Decodierungseinrichtung (104) nach Anspruch 11, wobei der Prozessor (104a) ferner zum Berechnen von u mittels der folgenden Gleichungen konfiguriert ist: 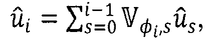 falls i ∈ F gilt und ${û}_{i} = arg {max}_{{u}_{i}} {W}_{{μ}_{i}}^{\left(i mod {2}^{{μ}_{i}}\right)} \left({y}_{{t}_{i}}^{{2}^{{μ}_{i}} + {t}_{i} - 1} , {û}_{{t}_{i}}^{i - 1} |{u}_{i}\right) ,$ falls i ∉ F gilt, wobei *φᵢ* ein Index einer Zeile der Matrix 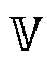 ist, die ein letztes Element ungleich Null in der Spalte i aufweist, wobei ${y}_{0}^{n - 1} = {y}_{0} … {y}_{n - 1} n$ rauschbehaftete Symbole des Codeworts c nach einer Übertragung über einen Kommunikationskanal 110 an die Decodierungseinrichtung bezeichnet, *µᵢ* = └log₂(2^{┌log₂*n*┐} - *i*)┘ gilt und *tᵢ* = 2^{┌log₂*n*┐}- *2*^{*µᵢ*+1} gilt.

13. Decodierungseinrichtung (104) nach Anspruch 12, wobei der Prozessor (104a) ferner zum Berechnen von *µ̂*_{*i*₁}, vor *µ̂*_{*i*₂}, falls *µ*_{*i*₂} = *µ*_{*i*₂} und i₁ < i₂ gilt, und zum Berechnen von 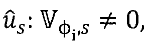 *s* < i vor *ûᵢ,* falls *i* E *F* gilt, konfiguriert ist.

14. Verfahren (600) zum Decodieren eines Codeworts c der Länge n, wobei das Verfahren die folgenden Schritte umfasst:
Decodieren (602) des Codeworts c unter Verwendung eines *C(n, k,* d)-Codes, wobei der Code *C*(*n, k, d*) eine Länge n und eine minimale Distanz *d* aufweist, wobei n = 2^{*m*₁} + ···+ 2*^{mₛ}* gilt, wobei *mₕ, h* = 1, ..., s eine ganze Zahl ist und s > 1 gilt, wobei: $c = uA ,$ wobei *uᵢ* = *xⱼᵢ,* 0 ≤ *jᵢ* < *k* - 1 gilt, wobei *x* Daten der Dimension *k* sind, falls i ∉ *F* gilt, wobei F ein Satz aus *n* - *k* eingefrorenen Bitindices des Codes *C(n, k, d)* ist und 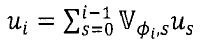 gilt, falls i ∈ F gilt, wobei V eine Bedingungsmatrix ist, die durch eine Lösung der folgenden Gleichung gegeben ist: 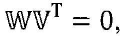 wobei *φᵢ* ein Index einer Zeile der Matrix 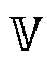 ist, die ein letztes Element ungleich Null in der Spalte *i* aufweist, wobei W eine Vorcodierungsmatrix ist und wobei *A* wie folgt definiert ist: $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ wobei ${A}_{{m}_{h}} = {\left(\begin{matrix}1 & 0 \\ 1 & 1\end{matrix}\right)}^{⊗ {m}_{h}}$ gilt und wobei *Q*^{⊗*m*} das *m*-te Kronecker-Produkt einer Matrix Q mit sich selbst bezeichnet,
wobei das Verfahren ferner Folgendes umfasst: Konstruieren des Codes *C*(*n, k, d*) basierend auf mehreren verschachtelten linearen Blockcodes *Cᵢⱼ*(2*^{mᵢ},K_{i,j},dᵢⱼ*), *K*_{*i,j*+1} > *K_{i,j}*, 0 ≤ *j* < *τᵢ*, wobei *τᵢ* eine positive ganze Zahl ist, wobei eine Generatormatrix von *Cᵢⱼ*(2*^{mᵢ},K_{i,j},dᵢⱼ*) durch die folgende Gleichung gegeben ist: ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ wobei *G*^{(*i,j*)} eine *k_{i,j}* × 2*^{mᵢ}* -Matrix ist, ${K}_{i , j} = {\sum }_{s = 0}^{j} {k}_{i , s}$ gilt, wobei eine Vorcodierungsmatrix von *G*^{(*i,j*)} durch ${W}^{\left(i, j\right)} = {G}^{\left(i, j\right)} {\left(\begin{matrix}1 & 0 \\ 1 & 1\end{matrix}\right)}^{⊗ {m}_{i}}$ definiert ist, wobei eine Vorcodierungsmatrix *G̃*^{(*i,j*)} durch ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}}$ definiert ist, wobei ein Index *l_{i,p}* einer Spalte, in der eine p-te Zeile der Matrix *W̃*^{(*i,τᵢ*-1)} startet, durch die Gleichung ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mᵢ}* definiert ist, und zum Konstruieren der Vorcodierungsmatrix W als eine Blockmatrix, wobei die Blöcke der Vorcodierungsmatrix W aus ausgewählten Zeilen der Matrizen *W̃*^{(*i,j*)} bestehen.

## Revendications

1. Appareil de codage (102) permettant de coder des données *x* de dimension *k* dans un mot de code c d'une longueur n, l'appareil de codage (102) comprenant :
un processeur (102a) configuré pour coder les données *x* à l'aide d'un code *C(n, k, d),* dans lequel le code *C(n, k, d)* a une longueur *n* et une distance minimum *d,* dans lequel n = 2^{*m*₁} + ···+ 2*^{mₛs},* dans lequel *mₕ, h* = 1, ..., *s* est un nombre entier et s > 1, sur la base de l'équation : $c = uA ,$ dans lequel *uᵢ* = *x_{jᵢ}*, 0 ≤ *jᵢ* < *k* - 1, si *i* ∉ F, dans lequel F est un ensemble de n - *k* indices de bits gelés du code *C(n, k, d),* et 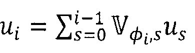 *uᵢ* si *i* ∈ F, dans lequel V est une matrice de contraintes donnée par une solution de l'équation : 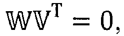 dans lequel *φᵢ* est un indice d'une rangée de la matrice 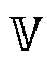 , qui a un dernier élément non nul dans la colonne i, dans lequel W est une matrice de pré-codage, et dans lequel A est défini comme suit : $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right)$ dans lequel ${A}_{{m}_{h}} = {\left(\begin{matrix}1 & 0 \\ 1 & 1\end{matrix}\right)}^{⊗ {m}_{h}} ,$ et dans lequel *Q*^{⊗*m*} indique les *m* fois du produit de Kronecker d'une matrice Q avec lui-même ;
dans lequel le processeur (102a) est configuré en outre pour élaborer le code *C(n, k, d)* sur la base d'une pluralité de codes de blocs linéaires imbriqués *Cᵢⱼ*(2*^{mᵢ},K_{i,j}, dᵢⱼ*), *K*_{*i,j+*1} > *K_{i,j},* 0 ≤ *j* < *τᵢ,* dans lequel *τᵢ* est un nombre entier positif, dans lequel une matrice génératrice de *Cᵢⱼ*(2*^{mᵢ},K_{i,j}*, *dᵢⱼ*) est donnée par l'équation : ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ dans lequel *G*^{(*i,j*)} est une matrice *k_{i,j}* × 2*^{mᵢ},* ${K}_{i , j} = {\sum }_{s = 0}^{j} {k}_{i , s} ,$ dans lequel une matrice de pré-codage de *G*^{(*i,j*)} est définie par ${W}^{\left(i, j\right)} = {G}^{\left(i, j\right)} {\left(\begin{matrix}1 & 0 \\ 1 & 1\end{matrix}\right)}^{⊗ {m}_{i}} ,$ dans lequel une matrice de pré-codage de *G̃*^{(*i,j*)} est définie par ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}} ,$ dans lequel un indice *l_{i,p}* d'une colonne, où une p^{e} rangée de la matrice *W̃*^{(*i*,*τᵢ*-1})commence, est défini par l'équation ${l}_{i , p} = {min}_{\begin{matrix}0 \leq t < {2}^{i} \\ {{W}^{˜}}_{p , t}^{\left(i,{τ}_{i}-1\right)} = 1\end{matrix}}$ 0 ≤ *p* < 2*^{mᵢ}*, et pour élaborer la matrice de pré-codage 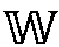 en tant que matrice de blocs, dans lequel les blocs de la matrice de pré-codage W se composent de rangées sélectionnées des matrices *W̃*^{(*i,j*)}.

2. Appareil de codage (102) selon la revendication 1, dans lequel la pluralité de codes de blocs linéaires imbriqués *Cᵢⱼ*(2*^{mᵢ},K_{i,j},dᵢⱼ*) sont des codes Bose-Chaudhuri-Hocquenghem (e-BCH) étendus.

3. Appareil de codage (102) selon l'une quelconque des revendications précédentes, dans lequel le processeur (102a) est configuré en outre pour élaborer une matrice de pré-codage 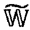 du code *C(n, k, d)* comme suit : 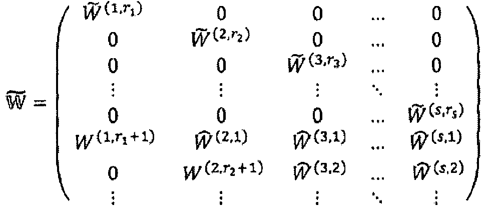 dans lequel *rᵢ* = *max*_{*j:d_{i,j}*≥}*_{d}j* est un indice d'un code e-BCH le plus important d'une longueur 2*^{mᵢ}* ayant une distance minimum d'au moins *d* et dans lequel *W̃*^{(*i,j*)} se compose de certaines rangées d'une matrice *W̃*^{(*i,τⱼ*)} et de rangées nulles, dans lequel *τⱼ* = *max*_{*s:d_{i,s}*≥}*_{δⱼ}* de sorte que pour n'importe quel s il existe au plus un bloc *i* ayant une rangée non nulle ${\hat{W}}_{s , -}^{\left(i, j\right)} .$

4. Appareil de codage (102) selon la revendication 3, dans lequel le processeur (102a) est configuré en outre pour élaborer la matrice *Ŵ*^{(*i,j*)} au moyen de rangées de la matrice *W̃*^{(*i,τⱼ*)} ayant la valeur la plus petite de *P_{mᵢ,lᵢ,p}*, dans lequel *P_{m,i}* est une probabilité d'erreur dans un sous-canal binaire ${W}_{m}^{\left(i\right)} \left({y}_{0}^{2 m - 1},{u}_{0}^{i - 1} |{u}_{i}\right) ,$ dans lequel ${y}_{0}^{{2}^{m} - 1} = {y}_{0} … {y}_{{2}^{m} - 1}$ indique 2*^{m}* - 1 symboles bruyants du mot de code c après une transmission sur un canal de communication (110).

5. Appareil de codage (102) selon l'une quelconque des revendications précédentes, dans lequel le processeur (102a) est configuré en outre pour élaborer une première pluralité de t rangées de la matrice 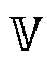 de telle façon que les derniers éléments non nuls dans la première pluralité de t rangées sont situés dans des positions distinctes *j,j* ≥ *j*₀ pour un nombre entier *j*₀, pour élaborer des éléments de la première pluralité de *t* rangées situées dans des colonnes ayant un indice z < *j* au moyen d'un générateur de nombres pseudo-aléatoires, et pour élaborer une seconde pluralité de n *- k - t* rangées d'une matrice 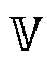 en tant que rangées distinctes d'une pondération.

6. Appareil de codage (102) selon la revendication 5, dans lequel le générateur de nombres pseudo-aléatoires est un registre à décalage à rebouclage linéaire.

7. Appareil de codage (102) selon l'une quelconque des revendications 3 et 4, dans lequel le processeur (102a) est configuré en outre pour agencer les rangées de la matrice *W*^{(*i,τᵢ*+1)} ou *Ŵ*^{(*j,i*)} dans un ordre ascendant des valeurs *l_{i,p}* et *l_{j,p}* respectivement.

8. Appareil de codage (102) selon l'une quelconque des revendications 3, 4 et 7, dans lequel le processeur (102a) est configuré pour élaborer la matrice W sur la base de *k* rangées de la matrice 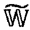 avec les valeurs les plus petites de *l_{i,p}.*

9. Procédé (500) permettant de coder des données *x* de dimension *k* dans un mot de code c d'une longueur n, le procédé comprenant les étapes suivantes :
le codage (502) des données *x* à l'aide d'un code *C(n, k, d),* dans lequel le code *C(n, k, d)* a une longueur *n* et une distance minimum *d,* dans lequel n = 2^{*m*₁} + ···+ 2*^{mₛ}*, dans lequel *mₕ, h =* 1, ..., s est un nombre entier, et s > 1, sur la base de l'équation : $c = uA ,$ dans lequel *uᵢ* = *xⱼᵢ*, 0 ≤ *jᵢ < k* - 1, si *i* ∉ *F*, dans lequel F est un ensemble de n - *k* indices de bits gelés du code *C(n, k, d),* et 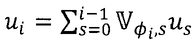 si *i* E F, dans lequel V est une matrice de contraintes donnée par une solution de l'équation : 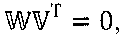 dans lequel *φᵢ* est un indice d'une rangée de la matrice 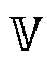 , qui a un dernier élément non nul dans la colonne i, dans lequel W est une matrice de pré-codage, et dans lequel A est défini comme suit : $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ dans lequel ${A}_{{m}_{h}} = {\left(\begin{matrix}1 & 0 \\ 1 & 1\end{matrix}\right)}^{⊗ {m}_{h}} ,$ et dans lequel *Q*^{⊗*m*} indique les *m* fois du produit de Kronecker d'une matrice Q avec lui-même ; le procédé comprenant en outre l'élaboration du code *C(n, k, d)* sur la base d'une pluralité de codes de blocs linéaires imbriqués *Cᵢⱼ*(2*^{mᵢ}*,*K_{i,j}*, *dᵢⱼ*), *K*_{*i,j*+1} > *K_{i,j}*, 0 ≤ *j* < *τᵢ*, dans lequel *τᵢ* est un nombre entier positif, dans lequel une matrice génératrice de *Cᵢⱼ*(2*^{mᵢ},K_{i,j},dᵢⱼ*) est donnée par l'équation : ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ dans lequel *G*^{(*i,j*)} est une matrice *k_{i,j}* × 2*^{mᵢ}*, ${K}_{i , j} = {\sum }_{s = 0}^{j} {k}_{i , s} ,$ dans lequel une matrice de pré-codage de *G*^{(*i,j*)} est définie par ${W}^{\left(i, j\right)} = {G}^{\left(i, j\right)} {\left(\begin{matrix}1 & 0 \\ 1 & 1\end{matrix}\right)}^{⊗ {m}_{i}} ,$ dans lequel une matrice de pré-codage de *G̃*^{(*i,j*)} est définie par ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}} ,$ dans lequel un indice *l_{i,p}* d'une colonne, où une p^{e} rangée de la matrice *W̃*^{(*i,τᵢ*-1)} commence, est défini par l'équation ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mᵢ},* et pour élaborer la matrice de pré-codage W en tant que matrice de blocs, dans lequel les blocs de la matrice de pré-codage W se composent de rangées sélectionnées des matrices *W̃*^{(*i,j*)}.

10. Appareil de décodage (104) permettant de décoder un mot de code c de longueur n, l'appareil de décodage (104) comprenant :
un processeur (104a) configuré pour décoder le mot de code c à l'aide d'un code *C(n, k, d),* dans lequel le code *C(n, k, d)* a une longueur *n* et une distance minimum *d,* dans lequel n = 2^{*m*₁} + ··· + 2*^{mₛ}*, dans lequel *mₕ, h* = 1, ..., s est un nombre entier et s > 1, dans lequel : $c = uA ,$ dans lequel *uᵢ* = *xⱼᵢ*, 0 ≤ *jᵢ < k* - 1, dans lequel *x* représente des données de dimension *k,* si *i* ∉ F, dans lequel F est un ensemble de *n* - *k* indices de bits gelés du code *C(n, k, d),* et 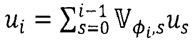 si *i* ∈ *F,* dans lequel V est une matrice de contraintes donnée par une solution de l'équation : 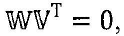 dans lequel *φᵢ* est un indice d'une rangée de la matrice 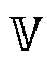 qui a un dernier élément non nul dans la colonne i, dans lequel W est une matrice de pré-codage, et dans lequel A est défini comme suit : $= \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ dans lequel ${A}_{{m}_{h}} = {\left(\begin{matrix}1 & 0 \\ 1 & 1\end{matrix}\right)}^{⊗ {m}_{h}} ,$ et dans lequel *Q*^{⊗*m*} indique les *m* fois du produit de Kronecker d'une matrice Q avec lui-même ; dans lequel le processeur (104a) est configuré en outre pour élaborer le code *C(n, k, d)* sur la base d'une pluralité de codes de blocs linéaires imbriqués *Cᵢⱼ*(2*^{mᵢ}*,*K_{i,j},dᵢⱼ*), *K*_{*i,j*+}1 > *K_{i,j},* 0 ≤ *j* < *τᵢ*, dans lequel *τᵢ* est un nombre entier positif, dans lequel une matrice génératrice de *Cᵢⱼ*(2*^{mᵢ}*,*K_{i,j}, dᵢⱼ*) est donnée par l'équation : ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ dans lequel *G*^{(*i,*j)}est une matrice *k_{i,j}* × 2*^{mi},* ${K}_{i , j} = {\sum }_{s = 0}^{j} {k}_{i , s} ,$ dans lequel une matrice de pré-codage de *G*^{(*i,j*)} est définie par ${W}^{\left(i, j\right)} = {G}^{\left(i, j\right)} {\left(\begin{matrix}1 & 0 \\ 1 & 1\end{matrix}\right)}^{⊗ {m}_{i}} ,$ dans lequel une matrice de pré-codage de *G̃*^{(*i,j*)} est définie par ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}} ,$ dans lequel un indice *l_{i,p}* d'une colonne, où une p^{e} rangée de la matrice *W̃*^{(i,*τᵢ*-1)} commence, est défini par l'équation ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mi},* et pour élaborer la matrice de pré-codage W en tant que matrice de blocs, dans lequel les blocs de la matrice de pré-codage W se composent de rangées sélectionnées des matrices *W̃*^{(*i,j*)}.

11. Appareil de décodage (104) selon la revendication 10, dans lequel le processeur (104a) est configuré en outre pour décoder le mot de code c au moyen d'une généralisation d'un algorithme d'annulation successif.

12. Appareil de décodage (104) selon la revendication 11, dans lequel le processeur (104a) est configuré en outre pour calculer u au moyen des équations suivantes : 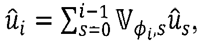 si *i* ∈ *F* et ${\hat{u}}_{i} = arg {max}_{{u}_{i}} {W}_{{μ}_{i}}^{\left(i mod {2}^{{μ}_{i}}\right)} \left({y}_{{t}_{i}}^{{2}^{{μ}_{i}} + {t}_{i} - 1},{\hat{u}}_{{t}_{i}}^{i - 1} |{u}_{i}\right) ,$ si *i* ∉ *F* dans lequel *φᵢ* est un indice d'une rangée de la matrice 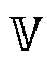 , qui a un dernier élément non nul dans une colonne *i,* dans lequel ${y}_{0}^{n - 1} = {y}_{0} … {y}_{n - 1}$ indique *n* symboles bruyants du mot de code c après une transmission sur un canal de communication 110 à l'appareil de décodage, *µᵢ* = └log₂(2^{┌log₂*n*┐} - *i*)┘ et *tᵢ* = 2^{┌log2*n*┐} - 2^{*µᵢ*+1}.

13. Appareil de décodage (104) selon la revendication 12, dans lequel le processeur (104a) est configuré en outre pour calculer *û*_{*i*₁} avant *û*_{*i*₂}, si *µ*_{*i*₁} = *µ*_{*i*₂} et *i*₁ < *i*₂, et pour calculer 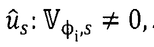 *s* < i, avant *ûᵢ* si i ∈ F .

14. Procédé (600) de décodage d'un mot de code c d'une longueur n, le procédé comprenant l'étape suivante :
le décodage (602) du mot de code c à l'aide d'un code *C(n, k, d),* dans lequel le code *C(n, k, d)* a une longueur *n* et une distance minimum *d,* dans lequel *n* = 2^{*m*₁} + ··· + 2*^{mₛ}*, dans lequel *mₕ, h* = 1, ... , *s* est un nombre entier et s > 1, dans lequel : $c = uA ,$ dans lequel *uᵢ* = *xⱼᵢ*, 0 ≤ *jᵢ < k* - 1, dans lequel *x* représente des données de dimension *k,* si *i* ∉ F, dans lequel F est un ensemble de *n* - *k* indices de bits gelés du code *C(n, k, d),* et 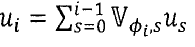 si i E F, dans lequel 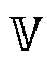 est une matrice de contraintes donnée par une solution de l'équation : 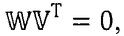 dans lequel *φᵢ* est un indice d'une rangée de la matrice 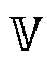 , qui a un dernier élément non nul dans la colonne i, dans lequel W est une matrice de pré-codage, et dans lequel A est défini comme suit : $A = \left(\begin{matrix}{A}_{{m}_{1}} & 0 & … & 0 \\ 0 & {A}_{{m}_{2}} & … & 0 \\ ⋮ & ⋮ & ⋱ & ⋮ \\ 0 & 0 & … & {A}_{{m}_{s}}\end{matrix}\right) ,$ dans lequel ${A}_{{m}_{h}} = {\left(\begin{matrix}1 & 0 \\ 1 & 1\end{matrix}\right)}^{⊗ {m}_{h}} ,$ et dans lequel *Q*^{⊗*m*} indique les *m* fois du produit de Kronecker d'une matrice Q avec lui-même ;
le procédé comprenant en outre l'élaboration du code *C(n, k, d)* sur la base d'une pluralité de codes de blocs linéaires imbriqués *Cᵢⱼ*(2*^{mᵢ}*,*K_{i,j},dᵢⱼ*), *K*_{*i,j*+1} > *K_{i,j}*, 0 ≤ *j* < *τᵢ*, dans lequel *τᵢ* est un nombre entier positif, dans lequel une matrice génératrice de *Cᵢⱼ*(2*^{mᵢ}*,*K_{i,j}*, *dᵢⱼ*) est donnée par l'équation : ${{G}^{˜}}^{\left(i, j\right)} = \left(\begin{matrix}{G}^{\left(i, 0\right)} \\ {G}^{\left(i, 1\right)} \\ ⋮ \\ {G}^{\left(i, j\right)}\end{matrix}\right) ,$ dans lequel *G*^{(*i,j*)} est une matrice *k_{i,j}* × 2*^{mi},* ${K}_{i , j} = {\sum }_{s = 0}^{j} {k}_{i , s} ,$ dans lequel une matrice de pré-codage de *G*^{(*i,j*)} est définie par ${W}^{\left(i, j\right)} = {G}^{\left(i, j\right)} {\left(\begin{matrix}1 & 0 \\ 1 & 1\end{matrix}\right)}^{⊗ {m}_{i}} ,$ dans lequel une matrice de pré-codage de *G̃*^{(*i,j*)} est définie par ${{W}^{˜}}^{\left(i, j\right)} = {{G}^{˜}}^{\left(i, j\right)} {\left(\begin{matrix}1 & 0 \\ 1 & 1\end{matrix}\right)}^{⊗ {m}_{i}} ,$ dans lequel un indice *l_{i,p}* d'une colonne, où une p^{e} rangée de la matrice *W̃*^{(*i*,*τᵢ*-1)} commence, est défini par l'équation ${l}_{i , p} = {min}_{\begin{matrix}0 \leq t < {2}^{i} \\ {{W}^{˜}}_{p , t}^{\left(i,{τ}_{i}-1\right)} = 1\end{matrix}} t ,$ 0 ≤ *p* < 2*^{mi},* et pour élaborer la matrice de pré-codage W en tant que matrice de blocs, dans lequel les blocs de la matrice de pré-codage W se composent de rangées sélectionnées des matrices *W̃*^{(*i,j*)}.
